(19) **Europäisches Patentamt / European Patent Office / Office européen des brevets**

(11) **EP 3 724 669 B1**

(12) **FASCICULE DE BREVET EUROPEEN**

(45) Date de publication et mention de la délivrance du brevet:
**26.01.2022 Bulletin 2022/04**

(21) Numéro de dépôt: **18833927.9**

(22) Date de dépôt: **12.12.2018**

(51) Classification Internationale des Brevets (IPC):
**G01R 31/00** *(2006.01)*

(52) Classification Coopérative des Brevets (CPC):
**G01R 31/008**

(86) Numéro de dépôt international:
**PCT/FR2018/053219**

(87) Numéro de publication internationale:
**WO 2019/115937 (20.06.2019 Gazette 2019/25)**

(54) **PROCEDE ET SYSTEME DE SURVEILLANCE D'UN RESEAU ELECTRIQUE MAILLE DE RETOUR DE COURANT D'UN AERONEF EN MATERIAU COMPOSITE**

VERFAHREN UND SYSTEM ZUR ÜBERWACHUNG EINES VERMASCHTEN ELEKTRISCHEN STROMRÜCKFÜHRUNGSNETZES FÜR EIN FLUGZEUG AUS VERBUNDWERKSTOFF

METHOD AND SYSTEM FOR MONITORING A MESHED CURRENT RETURN ELECTRICAL NETWORK FOR AN AIRCRAFT MADE OF COMPOSITE MATERIAL

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **13.12.2017 FR 1762093**

(43) Date de publication de la demande:
**21.10.2020 Bulletin 2020/43**

(73) Titulaires:
• **Safran Electrical & Power**
  **31702 Blagnac (FR)**
• **Centre National de la Recherche Scientifique**
  **75016 Paris (FR)**
• **Université Grenoble Alpes**
  **38400 Saint-Martin-d'Hères (FR)**

(72) Inventeurs:
• **DIEUDONNE, Anca-Lucia**
  **31700 Blagnac (FR)**
• **GODDET, Etienne**
  **69008 Lyon (FR)**
• **RETIERE, Nicolas Marie Henri**
  **38600 Fontaine (FR)**
• **GUICHON, Jean-Michel**
  **38100 Grenoble (FR)**

(74) Mandataire: **Cabinet Beau de Loménie**
  **158, rue de l'Université**
  **75340 Paris Cedex 07 (FR)**

(56) Documents cités:
**EP-A2- 2 653 859      FR-A1- 2 997 507**
**US-A1- 2010 127 564**

• **ZOU LIPING ET AL: "The application of neural network for Sneak Circuit Analysis on the aircraft electrical system", PROGNOSTICS AND SYSTEM HEALTH MANAGEMENT CONFERENCE (PHM-SHENZHEN), 2011, IEEE, 24 mai 2011 (2011-05-24), pages 1-5, XP031998478, DOI: 10.1109/PHM.2011.5939542 ISBN: 978-1-4244-7951-1**

**Description**

Arrière-plan de l'invention

L'invention concerne le domaine général de l'aéronautique.

Elle se rapporte plus particulièrement à la surveillance d'un réseau de retour de courant utilisé par les équipements électriques embarqués dans un aéronef tel que par exemple dans un avion.

L'alimentation électrique des équipements électriques embarqués à bord des aéronefs (aussi désignés par « charges électriques ») est traditionnellement assurée par une source électrique, reliée aux appareils via un câble d'alimentation, et par un réseau de retour de courant assurant une liaison basse impédance entre la source et les équipements électriques de l'aéronef. Une telle liaison basse impédance assure une chute de tension faible entre la source électrique et les diverses charges électriques embarquées dans l'aéronef, et par conséquent moins de pertes.

Traditionnellement, la fonction de retour de courant (ainsi qu'éventuellement d'autres fonctions complémentaires comme par exemple la métallisation, la protection au choc de foudre, la protection contre les champs rayonnés de forte intensité, la référence de potentiel, etc.) était assurée intrinsèquement par le fuselage et la structure métalliques des aéronefs. Toutefois, depuis quelques années, l'aéronautique voit l'essor des matériaux composites qui sont de plus en plus utilisés dans les structures primaires et secondaires des aéronefs. Ces matériaux composites ont de très bonnes propriétés mécaniques, mais ne supportent pas la circulation de courants ni les échauffements que ceux-ci peuvent engendrer.

Il a donc été nécessaire de prévoir pour les aéronefs en matériaux composites, un réseau électrique complémentaire permettant d'assurer pour les équipements électriques embarqués à bord de ces aéronefs la fonction de retour de courant. Des exemples de tels réseaux sont par exemple le réseau ESN (pour Electrical Structural Network) utilisé par Airbus et le réseau CRN (pour Current Return Network) utilisé par Boeing. Ces réseaux sont des réseaux basse impédance connectés en parallèle de la peau et de la structure composite de l'avion et qui permettent d'assurer les fonctions décrites précédemment.

Le réseau CRN est un réseau dédié aux fonctions électriques évoquées ci-dessus formé de câbles et de barres profilées interconnectés, formant un réseau maillé. Le réseau ESN quant à lui est un réseau maillé et redondé utilisant des éléments combinant à la fois des fonctionnalités mécaniques et électriques et faisant partie de la structure primaire et secondaire de l'aéronef, des protections des câbles et des harnais, des tresses, des câbles, etc.

Les technologies d'interconnexion utilisées actuellement pour connecter les éléments du réseau entre eux ne sont pas adaptées à la réalisation de contacts électriques fiables et viables. La vérification de chaque contact du point de vue électrique est en outre impossible en pratique. Les résistances de contact au niveau des interconnexions du réseau sont par conséquent assez mal maîtrisées, dépendant de nombreux paramètres et sont amenées à évoluer dans le temps. Ainsi, dans l'exemple d'une jonction entre deux éléments réalisés au moyen de boulons, la résistance de contact dépend notamment de la force de serrage des boulons, du type de boulons, de l'état des surfaces, etc.

Le réseau ESN se présente donc comme un réseau maillé de grande taille dans lequel les circulations des courants sont pilotées par les résistances de contact entre les différents éléments structurels du réseau. On comprend bien dès lors qu'il est nécessaire de surveiller plus particulièrement l'état des jonctions du réseau ESN réalisant l'interconnexion entre les différents éléments structurels sur lesquels s'appuie le réseau.

Le document EP 2 653 859 décrit une solution permettant de surveiller une jonction flexible ou électromécanique entre deux éléments structurels d'un réseau ESN. Cette solution s'appuie sur l'utilisation d'un transformateur de courant monté en abaisseur de tension pour injecter, le temps du contrôle, un courant alternatif de forte intensité dans un conducteur électrique mis en parallèle de la jonction à contrôler.

Cette solution repose sur l'hypothèse que le courant injecté passe en grande partie par la jonction que l'on cherche à surveiller. Or la plupart des résistances de contact au niveau des jonctions ne peuvent pas être mesurées directement, car elles sont connectées en parallèle au reste de la structure de l'aéronef. Une mesure de résistance donne en effet la valeur de la résistance de contact souhaitée en parallèle avec la résistance du reste du réseau, sans possibilité de discriminer entre les deux.

Le document FR 2 997 507 A1 décrit un procédé de surveillance d'un réseau maillé de retour de courant d'un aéronef.

Il existe donc un besoin d'un procédé de surveillance facile à mettre en œuvre et permettant de surveiller efficacement les éléments d'un réseau de retour de courant dans un aéronef, et plus particulièrement les jonctions utilisées par ce réseau pour l'interconnexion des éléments structurels de l'aéronef sur lesquels il s'appuie.

Objet et résumé de l'invention

La présente invention répond notamment à ce besoin en proposant un procédé de surveillance d'un réseau électrique maillé de retour de courant d'un aéronef, ledit aéronef comprenant au moins une structure en matériau composite, ledit réseau électrique comprenant une pluralité d'éléments conducteurs, ledit procédé de surveillance comprenant :

- une étape d'identification d'au moins un élément critique du réseau, pour au moins un couple source-charge comprenant une source et une charge de l'aéronef connectées au réseau ;
- une étape d'estimation paramétrique d'une valeur de la caractéristique électrique de chaque élément critique, cette étape utilisant un modèle numérique modélisant un comportement électrique du réseau en fonction de ladite caractéristique électrique et des mesures électriques réalisées au moyen de capteurs positionnés dans le réseau et permettant d'évaluer ledit comportement électrique, un capteur étant positionné dans le réseau pour chaque élément critique sur au moins un élément du réseau ou sur au moins un chemin du réseau formé d'une pluralité d'éléments du réseau influencé par une perturbation de la caractéristique électrique de cet élément critique ;
- une étape d'évaluation, pour ledit au moins un couple source-charge, d'un critère fonctionnel du réseau prédéfini, cette étape d'évaluation utilisant la valeur de la caractéristique électrique estimée pour chaque élément critique ; et
- une étape de détermination d'un état du réseau électrique en tenant compte du critère fonctionnel évalué pour ledit au moins un couple source-charge.

Corrélativement, l'invention concerne aussi un système de surveillance d'un réseau électrique maillé de retour de courant d'un aéronef, ledit aéronef comprenant au moins une structure en matériau composite, ledit réseau électrique comprenant une pluralité d'éléments conducteurs, ce système de surveillance comprenant :

- un dispositif d'identification, apte à identifier pour au moins un couple source-charge comprenant une source et une charge de l'aéronef connectées au réseau, au moins un élément critique au regard d'un état de fonctionnement du réseau (normal ou dégradé, ou d'un état de connectivité) parmi les éléments du réseau ;
- une pluralité de capteurs positionnés dans le réseau et aptes à réaliser des mesures électriques ;
- un module d'estimation paramétrique, configuré pour estimer une valeur de la caractéristique électrique de chaque élément critique, ce module utilisant un modèle numérique modélisant un comportement électrique du réseau en fonction de ladite caractéristique électrique et des mesures électriques réalisées au moyen desdits capteurs et permettant d'évaluer le comportement électrique, un capteur étant positionné dans le réseau pour chaque élément critique sur au moins un élément du réseau ou sur au moins un chemin du réseau formé d'une pluralité d'éléments du réseau influencé par une perturbation de la caractéristique électrique de cet élément critique ;
- un module d'évaluation, configuré pour évaluer pour ledit au moins un couple source-charge, un critère fonctionnel du réseau prédéfini, ce module utilisant la valeur de la caractéristique électrique estimée pour chaque élément critique ; et
- un module de détermination, configuré pour déterminer un état de fonctionnement du réseau électrique en tenant compte du critère fonctionnel évalué pour ledit au moins un couple source-charge considéré.

L'invention vise aussi un procédé d'identification d'éléments critiques d'un réseau électrique maillé de retour de courant d'un aéronef, cet aéronef comprenant au moins une structure en matériau composite, le réseau électrique comprenant une pluralité d'éléments conducteurs. Ce procédé d'identification comprend :

- une étape de modélisation du réseau électrique au moyen d'un graphe comprenant une pluralité de noeuds et une pluralité de branches reliant ces nœuds, chaque nœud du graphe correspondant à un point de connexion entre deux éléments du réseau, chaque branche entre deux nœuds représentant un élément du réseau, ledit graphe étant représenté par une matrice reflétant la topologie du réseau et comprenant des valeurs d'une caractéristique électrique des éléments du réseau représentés par les branches du graphe ;
- une étape de détermination des valeurs propres et des vecteurs propres de la matrice représentant le graphe ;
- une étape d'estimation, à partir des vecteurs propres et des valeurs propres de la matrice, et pour chaque élément d'une pluralité d'éléments du réseau représenté par une branche du graphe, d'une sensibilité d'une propriété électrique déterminée entre une source et une charge connectées au réseau électrique à une perturbation de la valeur de la caractéristique électrique de cet élément ; et
- une étape de détermination, parmi les éléments du réseau, d'éléments critiques au regard d'un état de fonctionnement du réseau, un élément du réseau étant déterminé comme critique lorsque la sensibilité de la propriété électrique estimée pour cet élément dépasse un seuil de criticité prédéterminé.

L'invention vise également un dispositif d'identification de points de connexion critiques dans un réseau électrique maillé de retour de courant d'un aéronef, ledit aéronef comprenant au moins une structure en matériau composite, ledit réseau électrique comprenant une pluralité d'éléments conducteurs, ledit dispositif d'identification comprenant :

- un module de modélisation, configuré pour modéliser le réseau électrique au moyen d'un graphe comprenant une pluralité de nœuds et une pluralité de branches reliant ces nœuds, chaque nœud du graphe correspondant à un point de connexion entre deux éléments du réseau, chaque branche entre deux nœuds représentant un élément du réseau, ledit graphe étant représenté par une matrice reflétant la topologie du réseau et comprenant des valeurs d'une caractéristique électrique des éléments du réseau représentés par les branches du graphe ;
- un module de détermination, configuré pour déterminer des valeurs propres et des vecteurs propres de la matrice représentant le graphe ;
- un module d'estimation, configuré pour estimer à partir des vecteurs propres et des valeurs propres de la matrice, et pour chaque élément du réseau représenté par une branche du graphe, d'une sensibilité d'une propriété électrique déterminée entre une source et une charge connectées au réseau électrique à une perturbation de la valeur de la caractéristique électrique de cet élément ; et
- un module de détermination, configuré pour déterminer parmi les éléments du réseau, des éléments critiques au regard d'un état de fonctionnement du réseau, un élément étant déterminé comme critique lorsque la sensibilité de la propriété électrique estimée pour cet élément dépasse un seuil de criticité prédéterminé.

Le procédé (respectivement le dispositif) d'identification selon l'invention est utilisé préférentiellement par le procédé (respectivement par le système) de surveillance pour identifier les éléments critiques du réseau électrique de retour de courant.

L'invention propose une méthode permettant de surveiller efficacement et simplement un réseau de retour de courant embarqué dans un aéronef.

Cette méthode repose sur une identification préalable des éléments critiques du réseau qui sont susceptibles notamment d'affecter la connectivité du réseau et sa capacité à remplir les fonctions pour lesquelles il a été dimensionné. De cette sorte, il est possible de simplifier la surveillance du réseau en se limitant à la surveillance de ces éléments critiques.

L'identification des éléments critiques proposée par l'invention a une complexité maîtrisée : elle s'appuie sur une représentation du réseau de retour de courant par un graphe, particulièrement bien adaptée pour un tel réseau, et nécessite un unique calcul numérique consistant à déterminer le spectre de la matrice représentant le graphe (i.e. ses valeurs propres et ses vecteurs propres). A partir des valeurs propres et des vecteurs propres de la matrice représentant le graphe, il est alors possible, via une simple étude perturbative de ces valeurs propres et de ces vecteurs propres, d'en déduire quels sont les éléments critiques du réseau à surveiller plus particulièrement pour s'assurer du fonctionnement normal de celui-ci. Ces éléments critiques sont identifiés en observant la sensibilité d'une propriété électrique du réseau (par exemple une chute de tension ou d'intensité dans le réseau) à des variations (perturbations) des caractéristiques électriques des éléments du réseau. En particulier, si cette sensibilité dépasse un seuil prédéterminé lors d'une perturbation appliquée à un élément donné, cet élément est considéré comme critique, car les variations de ses caractéristiques électriques sont susceptibles d'entrainer une défaillance du réseau.

Dans un mode privilégié de réalisation :

- la caractéristique électrique considérée est une admittance de l'élément du réseau ;
- la matrice du graphe est une matrice Laplacienne ; et
- la propriété électrique est une tension électrique entre la source et la charge considérée (ou une chute de tension entre ces deux éléments).

Il convient de noter que la modélisation sous forme de graphe, ainsi que la décomposition spectrale sur laquelle s'appuie l'invention et l'étude perturbative du spectre de la matrice du graphe appliquée par l'invention permettent avantageusement d'obtenir des relations analytiques directes entre les perturbations appliquées aux caractéristiques électriques des éléments du réseau et des composants du spectre du graphe, pour en déterminer ensuite la sensibilité des dites propriétés électriques du réseau face aux perturbations. Il en résulte un gain de temps substantiel par rapport aux méthodes classiques utilisant des calculs circuit et une complexité réduite de l'invention.

L'identification des éléments critiques du réseau permet de simplifier la surveillance du réseau, en se focalisant sur les éléments critiques. La surveillance proposée par l'invention permet de vérifier la connectivité des charges électriques embarquées dans l'aéronef et le respect de critères fonctionnels imposés au réseau.

Ce critère fonctionnel est par exemple une valeur maximale d'une chute de tension constatée entre chaque source et chaque charge, l'état du réseau électrique étant déterminé comme satisfaisant (ou normal) si cette chute de tension est, pour chaque couple source-charge, inférieure à ladite valeur maximale.

Un autre critère fonctionnel peut être une variation constatée entre la caractéristique électrique estimée pour un élément critique et une valeur nominale de cette caractéristique électrique, l'état du réseau électrique étant déterminé comme défaillant si pour au moins un élément critique du réseau pour au moins un couple source-charge, cette variation est supérieure à un seuil d'alerte prédéterminé.

Bien entendu d'autres critères fonctionnels peuvent être considérés.

L'invention permet ainsi de détecter facilement les dégradations d'éléments du réseau de retour de courant. Elle permet en outre de localiser facilement les éléments dégradés et de faciliter les opérations de maintenance sur le réseau.

Dans un mode particulier de réalisation, le procédé de surveillance comprend en outre une étape préliminaire de sélection, parmi une pluralité de charges de l'aéronef connectées au réseau électrique, d'au moins une charge considérée comme essentielle au regard du fonctionnement de l'aéronef, les étapes d'identification, d'estimation paramétrique, et d'évaluation étant appliquées uniquement aux couples source-charge comprenant ladite au moins une charge essentielle sélectionnée.

Cette sélection préliminaire permet de réduire la complexité de la surveillance mise en œuvre. Elle a en effet un impact sur le nombre d'éléments critiques considérés lors de la surveillance qui dépend des charges électriques prises en compte.

Dans un mode particulier de réalisation, lors de l'étape d'estimation paramétrique, on utilise autant de capteurs que d'éléments critiques identifiés, chaque capteur étant associé à un élément critique et placé sur l'élément du réseau ou sur le chemin du réseau le plus influencé par une perturbation de la valeur de caractéristique électrique de cet élément critique.

Ceci permet de limiter les mesures nécessaires pour estimer les caractéristiques techniques des éléments critiques lors de la surveillance. On s'assure dans ce mode de réalisation de disposer de mesures pertinentes pour évaluer de façon fiable ces caractéristiques techniques tout en limitant la complexité liée à la mise en œuvre de ces mesures. Les inventeurs ont constaté par le biais de tests que ce mode de réalisation conduit à un bon compromis entre complexité et fiabilité de la surveillance opérée, et permet d'optimiser le placement des capteurs dans le réseau.

Bien entendu, il est possible d'utiliser davantage de capteurs et de réaliser davantage de mesures pour améliorer la précision de la surveillance.

Dans un mode particulier de réalisation, l'étape d'estimation paramétrique met en œuvre une technique d'optimisation dite des points intérieurs sur une pluralité d'itérations.

Une telle technique est particulièrement efficace lorsque de nombreux paramètres doivent être optimisés. Toutefois d'autres techniques d'optimisation peuvent être utilisées en variante.

Dans un autre mode de réalisation, le procédé de surveillance comprend une étape préalable de caractérisation initiale des caractéristiques électriques à partir du graphe modélisant le réseau, de la matrice représentant le graphe et de mesures électriques réalisées dans le réseau.

Ainsi, la modélisation proposée par l'invention permet également la caractérisation initiale du réseau électrique de retour de courant et en particulier des caractéristiques électriques de ses éléments critiques (résistances de contact).

Brève description des dessins

D'autres caractéristiques et avantages de la présente invention ressortiront de la description faite ci-dessous, en référence aux dessins annexés qui en illustrent un exemple de réalisation dépourvu de tout caractère limitatif. Sur les figures :

- la figure 1 représente, dans son environnement, un système de surveillance d'un réseau électrique de retour de courant conforme à l'invention ;
- la figure 2 représente, sous forme d'ordinogramme, les principales étapes d'un procédé d'identification d'éléments critiques du réseau de retour de courant, conforme à l'invention, tel qu'il est mis en œuvre par le système de surveillance de la figure 1 ;
- les figures 3A et 3B illustrent un premier exemple de réseau et sa représentation par un graphe pouvant être utilisée lors du procédé d'identification représenté sur la figure 2 ;
- les figures 4A et 4B illustrent un second un exemple de réseau et sa représentation par un graphe pouvant être utilisée lors du procédé d'identification représenté sur la figure 2 ;
- la figure 5 représente les principales étapes d'un procédé de surveillance conforme à l'invention mis en oeuvre par le système de surveillance de la figure 1 ;
- la figure 6 représente un exemple de technique d'estimation paramétrique mise en œuvre lors du procédé de surveillance ; et
- les figures 7 à 9 illustrent un exemple d'application de l'invention.

Description détaillée de l'invention

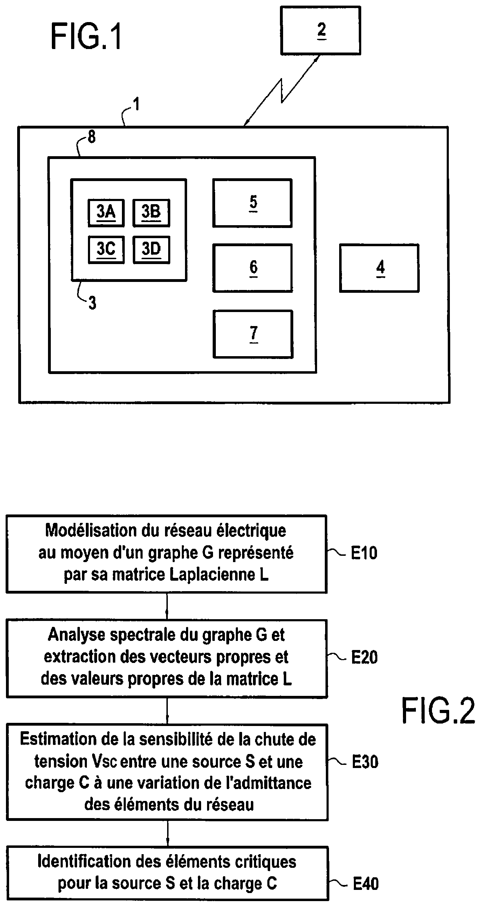

La **figure 1** représente, dans son environnement, un système de surveillance 1 d'un réseau électrique maillé 2 d'un aéronef, conforme à l'invention dans un mode particulier de réalisation.

Dans l'exemple envisagé ici, l'aéronef est un avion comprenant des structures internes ou externes en matériaux composites. A titre illustratif, on envisage ici que le fuselage de l'avion est en matériau composite, comprenant éventuellement une couche métallique (treillis métallique en surface des matériaux composites). Le fuselage est connecté aux autres éléments conducteurs du réseau par des boulons ou des rivets (qui sont eux aussi des éléments conducteurs).

Le réseau électrique 2 considéré est un réseau de retour de courant utilisé à bord de l'avion. Un tel réseau électrique assure, de façon connue en soi, le retour des courants fonctionnels des différentes charges électriques vers les différentes sources électriques de l'avion, mais peut également remplir une ou plusieurs des fonctions suivantes :

- métallisation et protection contre les défauts électriques ;
- protection contre les effets indirects de la foudre ;
- protection contre les champs rayonnés de forte intensité :
- référence de potentiel pour les équipements et les électroniques embarqués à bord de l'avion ; et
- protection des personnes à bord.

Il convient de noter qu'un réseau d'alimentation électrique d'un avion comporte plusieurs sources électriques (ex. sources de tension) : au moins un générateur électrique par moteur, un générateur électrique auxiliaire (APU - Auxiliary Power Unit), des batteries, un générateur associé à une turbine déployée en cas d'urgence (RAT - Ram Air Turbine). A terme, d'autres sources d'énergie électriques pourraient être envisagées (piles à combustibles, générateurs en bout d'aile, etc.).

Par souci de simplification dans la suite de la description on considère une unique source électrique et plusieurs charges dans l'avion.

Dans l'exemple envisagé ici, le réseau électrique 2 est un réseau ESN (Electrical Structural Network) tel que décrit par exemple dans le document EP 2 653 859 précédemment cité. Il s'agit d'un réseau basse impédance, connecté en parallèle du fuselage en matériau composite de l'avion, et reliant les différentes charges électriques de l'avion aux différentes sources électriques. Une liaison basse impédance assure avantageusement une chute (i.e. différence) de tension faible entre chaque charge et chaque source électrique de l'avion, et de ce fait moins de pertes.

Le réseau électrique 2 est maillé et redondé, chaque élément du réseau électrique étant relié à au moins deux autres éléments du réseau afin de respecter notamment les normes de sécurité en vigueur. Il s'appuie sur les composants métalliques de l'avion et comprend une pluralité d'éléments conducteurs de différentes natures, à savoir des éléments structurels constitués notamment de cadres métalliques, de traverses métalliques, de rails de sièges métalliques, du sol de cabine, etc., ainsi que de tout autre élément conducteur connecté en parallèle, tels que des chemins de câbles métalliques (raceways en anglais), des protections électromagnétiques, des tresses, des câbles ou des barres, ou tout élément de jonction réalisant l'interconnexion ou la connexion entre ces différents éléments. Les jonctions entre les différents éléments conducteurs du réseau électrique 2 sont réalisées par des éléments de fixation tels que des rivets, des boulons ou des vis. Les contacts entre les éléments du réseau électrique 2 peuvent être en conséquence des contacts complexes, réalisés à l'aide de plusieurs rivets, boulons ou vis, ou des contacts simples, réalisés à l'aide d'un seul rivet, boulon ou vis. Les contacts complexes concernent généralement les connexions électromécaniques entre des éléments structurels du réseau électrique 2, tandis que les contacts simples sont généralement réalisés entre les autres éléments du réseau ou entre les autres éléments du réseau et des éléments structurels.

On note que les segments d'éléments conducteurs du réseau définis de part et d'autre le cas échéant des différentes jonctions constituent eux-mêmes des éléments conducteurs du réseau au sens de l'invention.

Quelle que soit la jonction considérée entre deux éléments du réseau (structurels ou pas), il apparaît, au niveau du contact une résistance de contact. Les résistances induites par ces contacts électriques ne sont pas négligeables et impactent les circulations de courant dans le réseau électrique 2 et son état de connectivité.

Dans l'exemple envisagé ici, pour faciliter la compréhension de l'invention, on s'attache uniquement au retour des courants continus assuré par le réseau électrique 2. Le réseau électrique 2 est supposé ici être un réseau électrique résistif, chaque élément du réseau pouvant être assimilé à une admittance (définie comme l'inverse de l'impédance). Comme nous avons fait l'hypothèse d'être en courant continu, les parties inductives et capacitives de l'impédance sont nulles, donc l'impédance est égale à la résistance et par conséquent, l'admittance est l'inverse de la résistance.

Toutefois, ces hypothèses ne sont pas limitatives en soi et l'invention s'applique bien entendu à d'autres types de réseaux, et à d'autres caractéristiques électriques permettant de caractériser les éléments du réseau. Ainsi, la prise en compte des courants alternatifs ou impulsionnels peut être envisagée. Cela implique un calcul fréquentiel, donc la prise en compte des inductances et des capacités des éléments du réseau, ainsi que des couplages inductifs et des capacitifs entre les différents éléments du réseau. La prise en compte des aspects fréquentiels complexifie les modèles, mais ne change pas la démarche présenté dans cette étude.

Le système de surveillance 1 est avantageusement apte à surveiller et à déterminer l'état du réseau électrique 2 lorsque celui-ci est en fonctionnement ou excité par des courants judicieusement choisis. Par état du réseau, on entend ici son état de fonctionnement (par exemple, état normal/satisfaisant ou état défaillant) et sa capacité à assurer les fonctions primaires pour lesquelles il est prévu et dimensionné, et plus particulièrement sa fonction de retour des courants continus entre les charges et les sources électriques de l'aéronef. Cet état est évalué par le système de surveillance 1 au regard d'un critère fonctionnel prédéfini représentatif du fonctionnement du réseau (normal ou dégradé et/ou de son état de connectivité). Dans l'exemple envisagé ici, le critère fonctionnel considéré est une chute de tension maximale entre les sources et les charges de l'aéronef : autrement dit, toutes les chutes de tension constatées entre chaque source et chaque charge de l'aéronef doivent être inférieures à une valeur maximale prédéterminée. Le critère fonctionnel est considéré ici comme respecté (et l'état du réseau est considéré comme satisfaisant) si cette chute de tension maximale est inférieure à la chute de tension maximale imposée par le système d'ordre supérieur. Par système d'ordre supérieur, on entend tout système électrique utilisant tout ou une partie du réseau électrique 2 pour assurer le bon fonctionnement d'un équipement électrique en régime normal de fonctionnement ou en régime dégradé. Dans la suite de la description, à titre illustratif, on considère une chute de tension maximale de 0,5 V.

Bien entendu, d'autres critères fonctionnels peuvent être envisagés en variante par le système de surveillance 1 pour juger de l'état du réseau électrique 2, comme par exemple un critère fonctionnel portant sur une intensité de courant, sur une variation des résistances de contact au sein du réseau, etc.

Pour surveiller l'état du réseau électrique 2, le système de surveillance 1 s'appuie sur diverses entités. Plus particulièrement, il comprend :

- un dispositif d'identification 3 conforme à l'invention, apte à identifier parmi les différents éléments du réseau 2, un ou plusieurs éléments dits critiques. Par élément critique, on entend ici un élément susceptible de dégrader fortement la connectivité des charges de l'aéronef en cas de dysfonctionnement ou de dégradation. Dans l'exemple envisagé ici, on considère que les éléments critiques du réseau électrique 2 se situent au niveau des contacts assurés par les jonctions du réseau électrique 2, et non au niveau des éléments structurels du réseau à proprement parler qui sont considérés comme fiables. L'identification de ces éléments critiques permet de simplifier la surveillance du réseau 2, qui est alors limitée à la surveillance de ces éléments critiques ;
- une pluralité de capteurs 4 positionnés dans le réseau électrique 2 permettant de réaliser des mesures électriques. De tels capteurs sont par exemple des capteurs de champ (électrique ou magnétique), de courant, de tension, etc. classiquement utilisés pour réaliser des mesures électriques ; et
- une pluralité de modules comprenant notamment :

    ◦ un module d'estimation paramétrique 5 : ce module est configuré pour estimer les valeurs des caractéristiques électriques des éléments critiques. On s'intéresse ici aux valeurs des admittances des éléments critiques. Le module d'estimation paramétrique 5 utilise à cet effet, comme détaillé davantage ultérieurement, un modèle numérique modélisant le comportement électrique du réseau 2 en fonction des admittances de ses éléments et, des mesures électriques réalisées au moyen des capteurs 4 dûment positionnés dans le réseau pour permettre l'évaluation du comportement électrique de celui-ci lorsqu'il est en fonctionnement normal, en régime dégradé ou alimenté sur un schéma précis ;
    ◦ un module d'évaluation 6 : ce module est configuré pour évaluer pour différents couples source-charge, le critère fonctionnel auquel on s'attache pour déterminer l'état du réseau (chute de tension maximale inférieure à 0.5V ici). Il utilise à cet effet les valeurs des caractéristiques électriques des éléments critiques estimés par le module d'estimation 5 ; et
    ◦ un module de détermination 7 : ce module est configuré pour déterminer un état du réseau électrique 2 en tenant compte du critère fonctionnel évalué par le module d'évaluation 6 sur l'ensemble des couples source-charge considérés.

Les fonctions des modules 5-7 du système de surveillance sont détaillées davantage ultérieurement.

Dans le mode de réalisation décrit ici, les modules 5-7 sont des modules logiciels définis par des instructions d'un ou de plusieurs programmes d'ordinateurs stockés dans la mémoire morte d'un ordinateur 8, et lisibles par un processeur de cet ordinateur. Cet ordinateur peut être embarqué par exemple à bord de l'aéronef.

Dans le mode de réalisation décrit ici, le dispositif d'identification 3 selon l'invention est également intégré dans l'ordinateur 8 et s'appuie sur les moyens matériels de cet ordinateur. Conformément à l'invention, le dispositif d'identification 3 comprend divers modules logiciels ici, définis par des instructions de programmes d'ordinateurs, lisibles par le processeur de l'ordinateur 8 et stockées dans sa mémoire morte. Ces instructions, lorsqu'elles sont lues par le processeur de l'ordinateur 8, conduisent à l'exécution d'un procédé d'identification selon l'invention.

Les différents modules du dispositif d'identification 3 comprennent notamment :

- un module de modélisation 3A : ce module est configuré pour modéliser le réseau électrique 2 au moyen d'un graphe G comprenant une pluralité de nœuds et une pluralité de branches reliant ces nœuds. Comme détaillé davantage ultérieurement, chaque nœud du graphe correspond à un point de connexion entre deux éléments du réseau : il peut s'agir d'un point de connexion entre deux éléments structurels du réseau ou entre un élément structurel du réseau et une jonction utilisée pour relier cet élément structure à un autre élément structurel du réseau, etc. Chaque branche entre deux nœuds représente donc un élément du réseau, qu'il s'agisse d'un élément structurel (ou d'un segment d'un élément structurel du réseau), d'une jonction assurant une connexion entre deux éléments structurels ou de tout autre élément conducteur du réseau. Le graphe est représenté par une matrice reflétant la topologie du réseau et comprenant des valeurs d'une caractéristique électrique des éléments du réseau représentés par les branches du graphe. Le graphe G est représenté, au niveau du module de modélisation 3A, par une matrice notée dans la suite L reflétant la topologie du réseau 2 (c'est-à-dire ses éléments conducteurs et les interconnexions entre ses différents éléments conducteurs), et comprend les valeurs de caractéristiques électriques des éléments du réseau, à savoir ici les valeurs de leurs admittances ;

- un module de détermination 3B : ce module est configuré pour déterminer les valeurs propres et les vecteurs propres de la matrice L ;
- un module d'estimation 3C : ce module est configuré pour estimer, à partir des vecteurs propres et des valeurs propres de la matrice L, et pour chaque élément d'une pluralité d'éléments du réseau représentés par une branche du graphe, la sensibilité d'une propriété électrique du réseau déterminée entre une source et une charge de l'aéronef à une perturbation de la valeur de la caractéristique électrique comprise dans la matrice L de cet élément. Par sensibilité d'une propriété électrique, on entend ici une variation de cette propriété électrique en réponse aux perturbations appliquées aux caractéristiques électriques des éléments du réseau. Dans l'exemple envisagé ici, la caractéristique électrique perturbée est l'admittance de chaque élément et la propriété électrique en question est une tension entre la source et la charge (désignée dans la suite de la description compte tenu du contexte par « chute » de tension entre la source et la charge). Elle est choisie en liaison avec le critère fonctionnel auquel le système de surveillance s'intéresse pour déterminer l'état du réseau 2 (à savoir ici la chute de tension maximale entre toutes les sources et les charges de l'aéronef). Toutefois, en variante d'autres propriétés peuvent être estimées (par exemple une intensité, une résistance entre la source et la charge, etc.) ; et
- un module de détermination 3D : ce module est configuré pour déterminer parmi les éléments du réseau 2, des éléments critiques au regard de la propriété électrique considérée (tension ici) pour la source et la charge auxquelles on s'intéresse. Le module de détermination 3D identifie un élément comme critique lorsque la sensibilité à la perturbation appliquée à la valeur de l'admittance de cet élément dépasse un seuil de criticité prédéterminé noté THR. Un tel élément critique est en effet susceptible de dégrader fortement la connectivité des charges de l'aéronef en cas de dysfonctionnement ou de dégradation. Dans l'exemple envisagé ici, THR = 2% de la chute de tension maximale autorisée (0.5V ici) .

Les fonctions des différents modules du dispositif d'identification 3 sont décrites plus en détail maintenant en référence aux étapes du procédé d'identification selon l'invention.

Comme mentionné précédemment, l'invention offre une solution efficace permettant la surveillance de l'état d'un réseau électrique 2. Cette surveillance vise à vérifier le respect par le réseau électrique 2 d'un critère fonctionnel prédéfini du réseau. Comme indiqué précédemment, dans l'exemple envisagé ici, le critère fonctionnel est considéré comme respecté (et l'état du réseau est jugé normal ou satisfaisant par le système de surveillance 1) si la chute de tension maximale aux bornes de tous les couples source-charge de l'aéronef est inférieure à une chute de tension maximale prise égale à 0.5V lors du fonctionnement normal du réseau 2.

La surveillance mise en oeuvre par l'invention se concentre avantageusement sur un nombre limité d'éléments du réseau 2, à savoir sur les éléments identifiés comme critiques par le dispositif d'identification 3 pour chaque couple source-charge de l'aéronef considéré lors de la surveillance. En effet, comme indiqué précédemment, ces éléments critiques sont les éléments du réseau 2 qui sont susceptibles de dégrader le plus fortement la connectivité des charges de l'aéronef en cas de dysfonctionnement ou de dégradation, et donc qui risquent de rendre le réseau électrique 2 de retour de courant non fonctionnel. L'identification de ces éléments critiques permet de simplifier la surveillance du réseau 2.

Nous allons décrire, en référence à la **figure 2,** les principales étapes mises en œuvre par le dispositif d'identification 3 pour identifier ces éléments critiques du réseau 2. Ces éléments critiques peuvent varier d'une charge à l'autre. Ils sont donc identifiés pour chaque charge de l'aéronef considérée lors de la surveillance du réseau électrique de retour de courant.

Pour mieux comprendre le principe de l'invention, il est parfois détaillé dans la suite les hypothèses et les développements mathématiques sur lesquels se sont appuyés les inventeurs pour configurer le dispositif d'identification 3 en vue d'identifier les éléments critiques du réseau 2.

Conformément à l'invention, pour identifier les éléments critiques du réseau 2, le dispositif d'identification 3 s'appuie sur une modélisation numérique du réseau électrique. Plus précisément, le dispositif d'identification 3, via son module de modélisation 3A, modélise le réseau électrique 2 au moyen d'un graphe complexe G (étape E10).

De façon connue, un graphe est constitué d'un ensemble de nœuds reliés par des branches (ou liens). L'utilisation d'un graphe pour modéliser un réseau maillé tel que le réseau électrique 2 est donc particulièrement bien adaptée.

Chaque nœud du graphe complexe G correspond à un point de connexion entre deux éléments conducteurs du réseau électrique 2. Chaque branche du graphe représente un élément conducteur du réseau électrique 2 (élément structurel, segment d'élément structurel ou tout autre élément conducteur faisant partie du réseau électrique 2) . Chaque connexion (jonction) nécessitant au moins une vis est représentée par deux nœuds dans le graphe, ayant les mêmes coordonnées, et une branche de longueur 0 et de poids égal à la valeur de la résistance de contact équivalente.

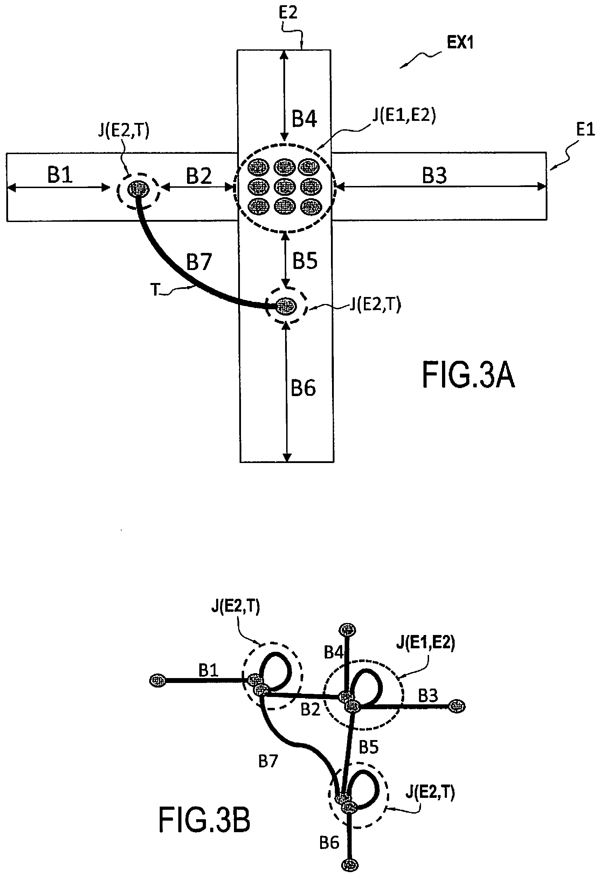

A titre illustratif, pour mieux comprendre comment un tel graphe G est construit, les figures 3A et 3B représentent respectivement une portion de réseau électrique EX1 et le graphe complexe G(EX1) modélisant cette portion de réseau électrique.

Plus spécifiquement, la **figure 3A** représente différents éléments conducteurs du réseau EX1 comprenant notamment deux éléments structurels E1 et E2 et une tresse T. Divers points de connexion existent entre ces éléments conducteurs et sont caractérisés par une jonction J(E1,T) entre l'élément structurel E1 et la tresse T, une jonction J(E2,T) entre l'élément structurel E2 et T, et une jonction J(E1,E2) entre les deux éléments structurels J1 et J2. On suppose que ces jonctions sont réalisées par exemple au moyen d'une vis. On désigne par segments, les portions des éléments structurels situés de part et d'autre de ces jonctions. Ainsi, chacun des éléments structurels E1 et E2 est composé respectivement de plusieurs segments, à savoir des segments B1, B2 et B3 pour l'élément E1, et des segments B4, B5 et B6 pour l'élément E2. On note que chaque segment constitue en soi un élément conducteur du réseau au sens de l'invention.

La **figure 3B** représente le graphe G(EX1) modélisant la portion de réseau électrique EX1 illustrée à la figure 3A. Comme mentionné précédemment, chaque connexion nécessitant au moins une vis est représentée par 2 nœuds dans le graphe, ayant les mêmes coordonnées, et une branche de longueur 0 et de poids égal à la valeur de la résistance de contact équivalente. Ainsi, qu'il s'agisse d'une connexion entre un élément de structure et une tresse (comme les jonctions J(E1,T) et J(E2,T) ou tout autre élément conducteur du réseau électrique 2, ou bien une connexion entre deux éléments de structure (comme la jonction J(E1,E2)), les « points » de connexion sont représentés de la même manière. Les branches du graphe correspondent soit à des éléments du réseau, soit à des segments du réseau (comme dans l'exemple illustré sur la figure 3B). Les poids des branches du réseau (B1 à B7 à titre d'exemple) qui ne sont pas des résistances de contact sont égaux aux valeurs des résistances des segments des éléments respectifs.

De cette sorte, le graphe complexe G modélise non seulement l'interconnexion des éléments structurels et des autres éléments conducteurs connectés en parallèle sur lesquels s'appuie le réseau mais également les contacts établis au niveau de chaque point de connexion entre ces différents éléments.

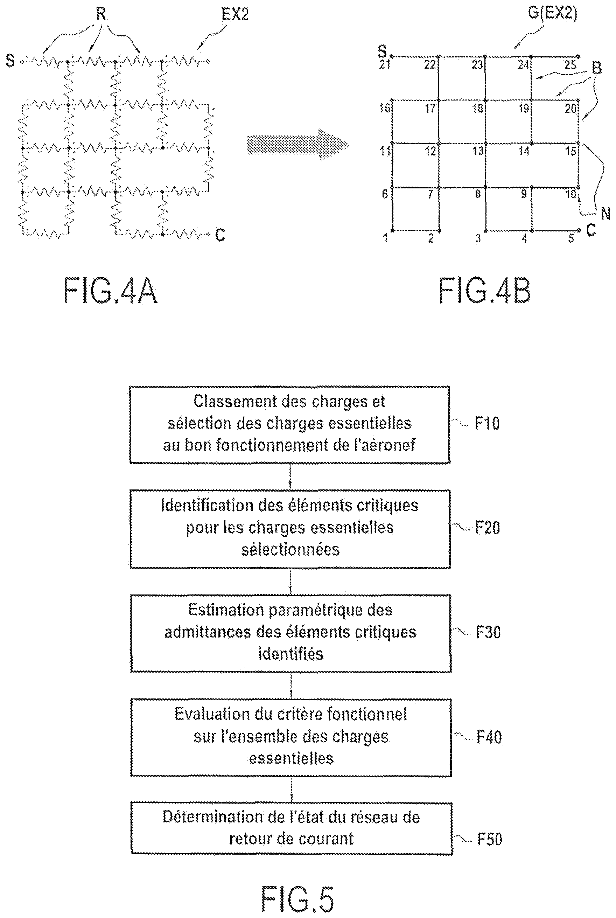

Un autre exemple est illustré aux figures 4A et 4B.

La **figure 4B** représente un graphe complexe G(EX2) modélisant le réseau électrique résistif EX2 représenté à la **figure 4A.** Le réseau électrique EX2 comprend 35 résistances identiques R qui sont modélisées par 35 branches B sur le graphe G(EX2) reliant entre eux 25 nœuds. Les 25 nœuds N du graphe G(EX2) représentent les interconnexions entre les résistances R du réseau électrique 2ex. Chaque branche du graphe G(EX2) est caractérisée par une admittance.

Le graphe G peut être représenté par une matrice L reflétant la topologie du réseau électrique 2 ainsi que les caractéristiques électriques de ses éléments. Dans l'exemple envisagé ici, comme mentionné précédemment, on s'intéresse comme caractéristiques électriques aux admittances des éléments du réseau 2. Chaque branche du graphe G est donc associée à une admittance qu'il s'agisse d'une admittance associée à un élément structurel du réseau (égale dans ce cas à l'inverse de son impédance, c'est-à-dire dans l'exemple résistif envisagé ici à l'inverse de sa résistance), ou d'une admittance correspondant à une résistance de contact au niveau d'une jonction.

La matrice L utilisée par le module de modélisation 3A pour représenter le graphe G est ici la matrice Laplacienne du graphe G modélisant le réseau électrique 2. Les composantes L(u,v) de cette matrice de dimensions nxn où n désigne le nombre de nœuds du graphe G sont définies par, pour u et v désignant des nœuds du graphe :

$$L(u,v) = \begin{cases} -y_{uv} \text{ si } u \text{ et } v \text{ sont adjacents,} \\ \sum_{t \in nei(u)} y_{ut} \text{ si } u = v, \\ 0 \text{ sinon.} \end{cases}$$

où $y_{uv}$ désigne l'admittance associée à la branche reliant les nœuds u et v, et nei(u) désigne l'ensemble des nœuds voisins du graphe G directement connectés au nœud u.

En variante, une autre matrice représentant le graphe G peut être envisagée, comme par exemple une matrice d'adjacence.

Suite à cette modélisation, le module de détermination 3B du dispositif d'identification 3 réalise une analyse spectrale du graphe G et notamment de sa matrice Laplacienne L. Cette analyse spectrale consiste à extraire les valeurs propres et les vecteurs propres de la matrice Laplacienne L (étape E20). Les valeurs propres et les vecteurs propres de la matrice L sont aussi connus sous le nom de spectre de la matrice Laplacienne L.

Pour déterminer le spectre de la matrice Laplacienne L, le module de détermination 3B utilise des techniques de diagonalisation de la matrice L connues en soi et non décrites en détail ici.

De façon connue, les n valeurs propres $\theta=(\theta_1,\theta_2,...,\theta_n)$ de la matrice Laplacienne L de dimensions nxn sont les n racines du polynôme caractéristique :

$$\det(L - \theta * J) = 0$$

où J désigne la matrice identité, et det le déterminant. La matrice Laplacienne étant symétrique et semi-définie positive, toutes ses valeurs propres sont réelles et positives. On note de plus que la matrice Laplacienne d'un graphe a au moins une valeur propre égale à 0, la multiplicité de cette valeur propre nulle étant égale au nombre de nœuds formant des clusters connectés dans le graphe.

Dans la suite de la description, on suppose que les valeurs propres de la matrice L vérifient :

$$\theta_1 = 0 \le \theta_2 \le ... \le \theta_n$$

Les vecteurs propres droits $\psi_i$ et gauches $\phi_i$ associés à la ième valeur propre $\theta_i$ sont définis par :

$$L\psi_i = \theta_i\psi_i \text{ et } \phi_i L = \theta_i\phi_i$$

Seuls les vecteurs propres droits sont utilisés dans la suite de la description. On utilise ici la notation suivante, pour désigner la matrice regroupant les vecteurs propres droits de la matrice L :

$$\dot{\Psi} = \begin{bmatrix} \psi_1 & \psi_2 & . & . & \psi_n \end{bmatrix}$$

On suppose en outre que les vecteurs propres droits sont orthogonaux entre eux soit :

$$\psi_i'.\psi_j = 0 \text{ si } i \ne j, \text{ i=1...n, j=1,...,n}$$

et qu'ils sont normalisés soit :

$$\psi_i'.\psi_i = 1,$$

ce qui implique que $\psi'\psi = J$ .

Ces propriétés sont aussi valables pour les vecteurs propres gauches.

Le spectre de la matrice Laplacienne L est ensuite utilisé par le module d'estimation 3C du dispositif d'identification 3 pour estimer pour chaque élément d'une pluralité d'éléments du réseau représenté par une branche du graphe G, la sensibilité d'une propriété électrique déterminée entre une source et une charge connectées au réseau électrique, à une perturbation de la valeur de la caractéristique électrique de cet élément du réseau (étape E30).

Dans le mode de réalisation décrit ici, le module d'estimation 3C considère plus particulièrement comme propriété électrique du réseau, la tension (ou chute de tension) $V_{SC}$ entre une source S et une charge C d'un couple source-charge de l'aéronef connecté au réseau électrique 2, lorsque celui-ci est fonctionnel.

Pour déterminer les équations appliquées par le module d'estimation 3C pour estimer la sensibilité de la tension $V_{SC}$, les inventeurs ont conduit le raisonnement suivant.

La matrice Laplacienne L représentant le graphe du réseau électrique 2 peut s'écrire sous la forme :

$$L = \Psi\Delta\Psi'$$

où $\Delta$ désigne la matrice diagonale contenant les valeurs propres de L.

Par ailleurs, par définition, la matrice Laplacienne L relie les potentiels électriques notés $\underline{V}=(V_1,...,V_n)$ et les

courants nodaux notés $\underline{I}=(I_1,...,I_n)$ du graphe G (i.e. considérés en chaque noeud du graphe) via la relation :

$$L\underline{V}=\underline{I}$$

Il en découle que :

$$\underline{V} = \Psi\Delta^{\bullet}\Psi^{t}\underline{I}$$

où $\Delta^{\bullet}$ désigne la matrice pseudo-inverse de Moore-Penrose de $\Delta$.

La matrice $\Delta$ n'étant pas inversible, on considère en outre ici une relation mathématique de régularisation entre les potentiels nodaux $V_t$, à savoir :

$$\sum_t V_t = 0$$

Le potentiel électrique $V_i$ d'un nœud i peut donc s'écrire :

$$V_i = \sum_{j=1}^{n}(\sum_{k=2}^{n}\frac{\psi_k(i)\psi_k(j)}{\theta_k})I_j \qquad \text{Eq.1}$$

En outre, si l'on considère une source de courant électrique S et une charge C de l'aéronef connecté au réseau électrique 2, la résistance entre la source S et la charge C lorsque l'on fait transiter entre eux un courant I0 est :

$$R_{SC} = \frac{V_S - V_C}{I_0}$$

où $V_S$ désigne le potentiel de la source S et $V_C$ le potentiel de la charge C. En remplaçant $V_S$ et $V_C$ par la décomposition indiquée à l'équation (Eq. 1) fournie ci-dessus on obtient :

$$R_{SC} = \frac{1}{I_0}\left(\sum_{j=1}^{n}(\sum_{k=2}^{n}\frac{\psi_k(s)\psi_k(j)}{\theta_k})I_j - \sum_{j=1}^{n}(\sum_{k=2}^{n}\frac{\psi_k(c)\psi_k(j)}{\theta_k})I_j\right)$$

En faisant l'hypothèse que tous les courants nodaux étant nuls exceptés ceux des nœuds S et C et que :

$$I_s = -I_c = I_0$$

on obtient pour la résistance $R_{SC}$ :

$$R_{SC} = \frac{I_s}{I_0}\left(\sum_{k=2}^{n}\frac{\psi_k(s)^2 - 2\psi_k(s)\psi_k(c) + \psi_k(c)^2}{\theta_k}\right)$$
$$= \sum_{k=2}^{n}\frac{(\psi_k(s) - \psi_k(c))^2}{\theta_k} \qquad \text{Eq.2}$$

Il apparaît donc au regard des équations (Eq. 1) (en remplaçant dans l'équation le nœud i par la source S et par la charge C respectivement) et (Eq. 2) que la tension $V_{SC} = V_S - V_C$ entre la source S et la charge C et la résistance électrique $R_{SC}$ entre ces deux nœuds peuvent être déterminées à partir du spectre de la matrice L. Les inventeurs ont donc eu l'idée judicieuse de réaliser une étude perturbative du spectre de la matrice L en vue de prévoir les variations des propriétés électriques du réseau électrique 2 (à savoir notamment ici de la tension $V_{SC}$), lorsque des perturbations sont appliquées aux composantes de la matrice Laplacienne L du graphe G modélisant le réseau électrique 2. Ces perturbations sont liées à la modification de la structure du réseau 2 (par exemple en raison d'une dégradation d'un contact entre deux éléments structurels du réseau). On suppose ici que les perturbations de la matrice Laplacienne sont assez faibles afin de rester dans le domaine linéaire.

Dans la suite de la description, on note L0 la matrice Laplacienne du graphe G avant application des perturbations (L0 correspond à la matrice L considérée à l'étape E20 décrite précédemment). Toutes les notations relatives à cette matrice introduites précédemment (par exemple pour désigner les valeurs propres et les vecteurs propres de la matrice) sont conservées et indexées par 0.

L'équation reliant les ième valeur propre et vecteur propre de la matrice Laplacienne L0 est :

$$L_0 \psi_{0i} = \theta_{0i} \psi_{0i}$$

Lorsque le réseau 2 est perturbé (par exemple si une impédance de branche est augmentée à cause de la détérioration de la connexion entre les deux nœuds reliés par la branche), la matrice Laplacienne représentant le réseau 2 ainsi que son spectre sont modifiés. On note dans la suite L la matrice Laplacienne caractérisant le réseau électrique 2 après perturbation.

La relation entre les ième valeur propre et vecteur propre de la matrice Laplacienne perturbée L est :

$$L \psi_i = \theta_i \psi_i$$

Si la perturbation est faible, il est possible de calculer les valeurs propres et les vecteurs propres de la matrice Laplacienne L du réseau perturbé à partir du spectre de la matrice Laplacienne initiale L0, en linéarisant la relation indiquée ci-dessus. On note $\Delta L$, $\Delta \psi i$ et $\Delta \theta i$ les variations respectives appliquées à la matrice L0, et aux vecteurs propres droits $\psi i$ et aux valeurs propres $\theta i$ lorsque le réseau 2 est perturbé.

Plus particulièrement, il peut être démontré que les valeurs propres $\theta i$ et les vecteurs propres $\psi i$ de la matrice Laplacienne L perturbée peuvent s'écrire sous la forme suivante :

$$\theta_i = \theta_{i0} + \psi_{0i}{}' \Delta L \psi_{0i}$$

$$\psi_i = \psi_{0i} + \sum_{k \neq i}^{n} \frac{\psi_{0k}{}' \Delta L \psi_{0i}}{\theta_{0i} - \theta_{0k}} \psi_{0k}$$

Ces équations ont été utilisées judicieusement par les inventeurs pour déterminer les relations appliquées par le module d'estimation 3C du dispositif d'identification 3 pour estimer la sensibilité des potentiels nodaux Vi à une modification de l'admittance d'une branche du graphe. Il s'agit, en calculant cette sensibilité entre la source S et la charge C considérées pour différentes branches du graphe G (ou de manière équivalente, pour différents éléments du réseau 2), de déterminer quelles sont les branches qui, lorsque leur admittance est perturbée, conduisent à une sensibilité accrue (i.e. supérieure à un seuil prédéterminé). Ces branches désignent les éléments critiques du réseau 2 auxquels il convient de porter plus particulièrement attention lors de la détermination de l'état du réseau 2.

Plus précisément, lorsqu'une admittance non nulle $\Delta y_{uv}$ est ajoutée à l'admittance d'une branche quelconque reliant des nœuds u et v, il en découle une modification $\Delta L$ de la matrice Laplacienne vérifiant :

$$\Delta L = \begin{pmatrix} 0 & \cdots & 0 & \cdots & 0 \\ \vdots & \Delta y_{uv} & \vdots & -\Delta y_{uv} & \vdots \\ 0 & \cdots & 0 & \cdots & 0 \\ \vdots & -\Delta y_{uv} & \vdots & \Delta y_{uv} & \vdots \\ 0 & \cdots & 0 & \cdots & 0 \end{pmatrix}$$

(les composantes non nulles $+/-\Delta y_{uv}$ correspondent aux composantes se trouvant à l'intersection de la u-ième ligne et de la v-ième colonne).

Les valeurs propres de la matrice Laplacienne L0 sont alors modifiées de la façon suivante :

$$\theta_i = \theta_{0i} + \left(\Delta y_{uv}\left(\psi_{0i}(u) - \psi_{0i}(v)\right)^2\right)$$

Il résulte de cette relation que la sensibilité (i.e. variation en réponse à la perturbation $\Delta y_{uv}$ appliquée à la branche reliant les nœuds u et v) des valeurs propres de la matrice Laplacienne à la modification de l'admittance de la branche entre les nœuds u et v est :

$$\frac{\partial \theta_i}{\partial y_{uv}} = \left(\psi_{0i}(u) - \psi_{0i}(v)\right)^2 \qquad \text{Eq.3}$$

De manière similaire, les vecteurs propres du réseau perturbé vérifient la relation suivante :

$$\psi_i = \psi_{0i} + \Delta y_{uv} \sum_{k \neq i}^{n} \left[ \left( \frac{\psi_{0i}(u)\left(\psi_{0k}(u) - \psi_{0k}(v)\right)}{\theta_{0i} - \theta_{0k}} + \frac{\psi_{0i}(v)\left(\psi_{0k}(v) - \psi_{0k}(u)\right)}{\theta_{0i} - \theta_{0k}} \right) \psi_{0k} \right]$$

La sensibilité des vecteurs propres de la matrice Laplacienne à la modification de l'admittance de la branche entre les nœuds u et v est donc donnée par :

$$\frac{\partial \psi_i}{\partial y_{uv}} = \sum_{k \neq i}^{n} \left[ \left( \frac{\psi_{0i}(u)\left(\psi_{0k}(u) - \psi_{0k}(v)\right)}{\theta_{0i} - \theta_{0k}} + \frac{\psi_{0i}(v)\left(\psi_{0k}(v) - \psi_{0k}(u)\right)}{\theta_{0i} - \theta_{0k}} \right) \psi_{0k} \right] \qquad \text{Eq.4}$$

Dans le mode de réalisation décrit ici, le dispositif d'identification 3 utilise les sensibilités des valeurs propres et des vecteurs propres de la matrice Laplacienne du graphe G données respectivement par les équations (Eq.3) et (Eq.4) pour déterminer la sensibilité de la tension entre la source S et la charge C considérées à la variation de l'admittance de chaque branche du graphe.

Plus précisément, le potentiel électrique $V_{0i}$ du nœud i avant perturbations s'écrit :

$$V_{0i} = \sum_{j=1}^{n} \left( \sum_{k=2}^{n} \frac{\psi_{0k}(i)\psi_{0k}(j)}{\theta_{0k}} \right) I_j$$

où Ij désigne l'intensité nodale au nœud j. Après une petite variation de la matrice Laplacienne, ce potentiel électrique devient :

$$V_i = \sum_{j=1}^{n} \left( \sum_{k=2}^{n} \frac{\psi_k(i)\psi_k(j)}{\theta_k} \right) I_j$$

où $V_i = V_{0i} + \Delta V_i$, $\psi_i = \psi_{i0} + \Delta \psi_i$; et $\theta_i = \theta_{i0} + \Delta \theta_i$.

La modification du potentiel électrique résultant d'une petite perturbation appliquée sur une admittance est donc :

$$\Delta V_i = \sum_{j=1}^{n} I_j \left[ \sum_{k=2}^{n} \left( \frac{\left(\psi_{0k}(i) + \Delta\psi_k(i)\right)\left(\psi_{0k}(j)\right)}{\theta_{0k} + \Delta\theta_k} + \frac{\Delta\psi_k(j)}{\theta_{0k} + \Delta\theta_k} - \frac{\psi_{0k}(i)\psi_{0k}(j)}{\theta_{0k}} \right) \right]$$

soit, en négligeant les termes du second ordre :

$$\Delta V_i = \sum_{j=1}^{n} I_j \left[ \sum_{k=2}^{n} \left( \frac{\left(\Delta\psi_k(i)\psi_{0k}(j) + \Delta\psi_k(j)\psi_{0k}(i)\right)}{\left(\theta_{0k} + \Delta\theta_k\right)} - \frac{\Delta\theta_k\psi_{0k}(i)\psi_{0k}(j)}{\theta_{0k}\left(\theta_{0k} + \Delta\theta_k\right)} \right) \right]$$

La sensibilité du potentiel électrique $V_i$ du nœud i à la variation d'admittance de la branche du réseau 2 située entre les nœuds u et v vérifie donc l'équation (Eq.5) suivante :

$$\frac{\partial V_i}{\partial y_{uv}} = \sum_{j=1}^{n} I_j \left[ \sum_{k=2}^{n} \left( \frac{\theta_{0k} \frac{\partial \psi_k(i)}{\partial y_{uv}} \psi_{0k}(j) + \theta_{0k} \frac{\partial \psi_k(j)}{\partial y_{uv}} \psi_{0k}(i) - \frac{\partial \theta_k}{\partial y_{uv}} \psi_{0k}(i)\psi_{0k}(j)}{\left( \theta_{0k} + \Delta y_{uv} \frac{\partial \theta_k}{\partial y_{uv}} \right)^2} \right) \right]$$

A partir de cette équation, la sensibilité de la tension entre la source S et la charge C (autrement dit la sensibilité de la chute de tension mesurée entre ces deux nœuds) à la variation d'admittance d'une branche du réseau peut être aisément calculée par le module d'estimation 3C à partir de la relation :

$$\frac{\partial V_{sc}}{\partial y_{uv}} = \frac{\partial V_s}{\partial y_{uv}} - \frac{\partial V_c}{\partial y_{uv}}$$

dans laquelle les sensibilités des potentiels électriques $V_S$ et $V_C$ sont évaluées par le second module d'estimation 3C à partir de l'équation (Eq. 5) indiquée ci-dessus appliquée au nœud source S et au nœud charge C, et les sensibilités des vecteurs propres et des valeurs propres de la matrice L sont calculées à partir des équations (Eq.3) et (Eq.4).

Le module d'estimation 3C peut être configuré pour calculer la sensibilité de la tension à une variation d'admittance de chaque branche du graphe G. En variante, on peut faire l'hypothèse que seules les jonctions électromécaniques sont susceptibles d'affecter fortement la connectivité du réseau (en raison par exemple d'un boulon desserré, d'une dégradation du contact assurée par la jonction) afin de limiter les calculs : le module d'estimation 3C peut dans ce cas se limiter aux variations des admittances (i.e. des résistances de contact) des branches représentant ces jonctions électromécaniques, les autres admittances étant gardées fixes égales à leurs valeurs initiales. Il convient de noter que la dégradation des autres éléments du réseau correspond à une dégradation structurelle qui peut être détectée par d'autres moyens.

A partir des sensibilités estimées par le module d'estimation 3C, le module de détermination 3D du dispositif d'identification 3 est en mesure de déterminer (i.e. d'identifier) les éléments critiques du réseau 2 pour au moins un couple source-charge connecté au réseau (étape E40). Plus spécifiquement, un élément du réseau 2 est identifié comme critique par le module de détermination 3D lorsque la sensibilité de la tension $V_{SC}$ entre la source S et la charge considérées à la perturbation $\Delta y_{uv}$ appliquée à la valeur de l'admittance de cet élément critique (c'est-à-dire ici à la branche du graphe représentant cet élément) dépasse un seuil de criticité THR prédéterminé. En relation avec le critère fonctionnel considéré par le système de surveillance, le seuil de criticité THR est pris égal ici à 2% de la chute de tension maximale admissible entre la source électrique et la charge. Ainsi, tous les éléments du réseau pour lesquels la sensibilité de la tension $V_{SC}$ dépasse le seuil de criticité THR sont considérés comme critiques par le module de détermination 3D. Dans le mode de réalisation décrit ici, les autres éléments du réseau modélisés par une branche sont considérés comme fixes et leurs admittances sont prises égales à leur valeur initiale (valeur considérée dans la matrice Laplacienne L0 avant perturbation).

La surveillance de l'état du réseau électrique 2 peut donc se concentrer sur les éléments du réseau identifiés comme critiques à l'étape E40, pour chaque source électrique et chaque charge de l'avion connectées au réseau électrique 2. On note que le procédé d'identification fonctionne quel que soit le seuil de criticité THR choisi. Le choix de ce seuil de criticité impacte le compromis entre la précision des résultats obtenue et la rapidité d'exécution du procédé de surveillance. Ainsi, un seuil de criticité pris égal à 0 impose la prise en compte lors de la surveillance de tous les éléments du réseau électrique 2.

La **figure 5** représente, dans un mode particulier de réalisation, les principales étapes mises en œuvre lors de cette surveillance par le système de surveillance 1. Ces étapes correspondent aux étapes du procédé de surveillance selon l'invention.

La surveillance proposée par l'invention comprend, outre l'identification des éléments critiques du réseau à surveiller, plusieurs étapes qui visent à vérifier la connectivité des charges de l'avion et le respect du critère fonctionnel selon lequel les chutes de tension constatées entre les différentes charges et les différentes sources de l'avion sont inférieures à une chute de tension maximale admissible fixée ici à 0,5 V.

Dans le mode de réalisation décrit ici, pour simplifier la surveillance du réseau électrique 2, on considère une étape préliminaire de classement des différentes charges électriques de l'avion connectées au réseau électrique 2 en fonction de leur importance au regard du fonctionnement de l'avion. Cette étape est destinée à déterminer quelles sont les charges connectées au réseau électrique 2 qui sont critiques, c'est-à-dire déterminantes ou encore essentielles pour le bon fonctionnement de l'avion. Ce classement peut être établi à partir d'informations fournies par le systémier ou l'intégrateur aéronautique. Il permet au système de surveillance 1 de sélectionner, parmi la pluralité de charges de l'avion connectées au réseau électrique, un nombre réduit de charges à prendre en compte lors de la surveillance du réseau électrique (étape F10). Plus précisément, seules les charges les plus déterminantes désignées dans la suite par « essentielles » au regard du bon fonctionnement de l'avion sont sélectionnées par le système de surveillance 1. Ceci permet de limiter la complexité de mise en œuvre de la surveillance, celle-ci n'étant conduite qu'au regard des charges sélectionnées.

A partir des charges essentielles sélectionnées, le système de surveillance 1 identifie, par l'intermédiaire du dispositif d'identification 3, pour chaque couple source S - charge C comprenant une charge essentielle, les éléments critiques du réseau électrique 2 à considérer (étape F20). Cette identification est réalisée en appliquant à la source S et à chaque charge C le procédé d'identification selon l'invention, précédemment décrit en référence à la figure 2. Il convient de noter que des éléments du réseau peuvent être critiques pour des charges essentielles distinctes.

Le système de surveillance 1, par l'intermédiaire de son module d'estimation paramétrique 6, estime ensuite la valeur de l'admittance de chaque élément critique identifié par le dispositif d'identification 3 pour les différents couples source-charge considérés (étape F30).

A cet effet, le module d'estimation paramétrique 6 utilise un modèle numérique MOD modélisant le comportement électrique du réseau électrique 2 en fonction de l'admittance de ses éléments, et des mesures électriques réalisées au moyen des capteurs 4 permettant d'évaluer le comportement du réseau électrique 2 et de le comparer au comportement modélisé par le modèle numérique.

Dans le mode de réalisation décrit ici, le modèle numérique MOD considéré par le module d'estimation paramétrique 5 pour représenter le comportement du réseau électrique en fonction des admittances de ses éléments est le même modèle que celui utilisé par le dispositif d'identification, à savoir que dans le réseau 2, les potentiels électriques nodaux V sont reliés aux courants nodaux par l'intermédiaire des admittances des branches du graphe, selon la relation :

$$Y\underline{V}=\underline{I} \qquad\qquad\qquad (MOD)$$

où Y désigne la matrice des admittances des branches du graphe (autrement dit des éléments du réseau), cette matrice étant identique à la matrice Laplacienne. Ce modèle définit les équations circuits du réseau électrique 2.

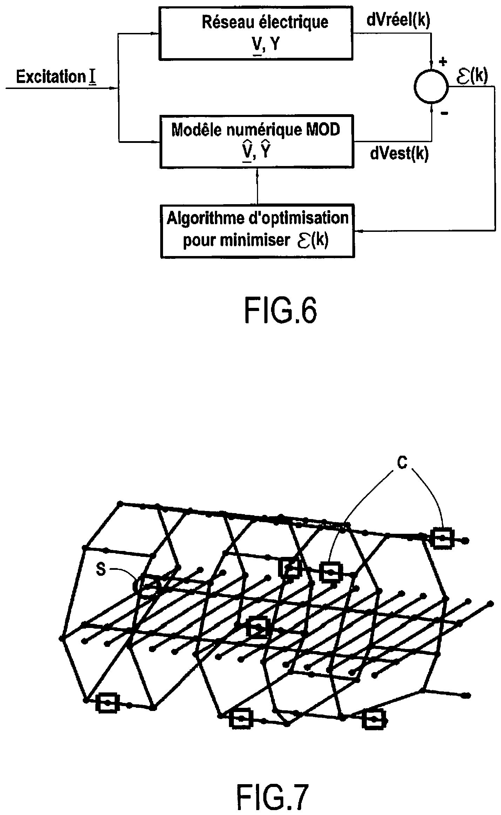

L'estimation paramétrique vise à déterminer les composantes de la matrice Y via une technique itérative. Cette technique est illustrée à **la figure 6.** Elle consiste de façon générale à exciter le réseau électrique 2 au moyen de courants nodaux continus (dans une ou plusieurs configurations), et à mesurer les chutes de tension résultant de l'excitation du réseau électrique au moyen de capteurs dûment positionnés dans le réseau électrique 2. Les chutes de tension correspondant aux courants d'excitation considérés sont par ailleurs estimées au moyen du modèle numérique MOD, et comparer aux chutes de tension mesurées. Les admittances sont estimées en minimisant la différence constatée entre les chutes de tension estimées et mesurées au moyen d'un algorithme d'optimisation. Cette optimisation peut être éventuellement répétée au cours d'une pluralité d'itérations pour permettre l'estimation de toutes les admittances des éléments critiques, les admittances déterminées au cours d'une itération étant considérées comme connues à l'itération suivante.

La technique d'estimation paramétrique mise en œuvre par le module d'estimation 5 s'appuie donc sur des mesures électriques (ex. mesures de potentiels, de chutes de tension et/ou de courants comme détaillé ultérieurement) réalisées au moyen des capteurs 4 au sein du réseau électrique 2. Le placement des capteurs 4 pour réaliser ces mesures est un paramètre important à prendre en compte qui impacte à la fois la complexité du procédé de surveillance et sa précision.

Pour déterminer (et optimiser) les emplacements des capteurs 4, les inventeurs ont considéré que plus la chute de tension mesurée est influencée par un élément critique du réseau (autrement dit par une branche du graphe), plus l'information obtenue grâce à la mesure de cette chute de tension est utile pour estimer l'admittance de cet élément critique. Ils ont donc décidé de l'emplacement des capteurs 4 en fonction des tensions (ou des courants) influencées par un ou plusieurs éléments critiques identifiés à l'étape F20.

Il convient de noter que le nombre de capteurs 4 à placer dans le réseau électrique 2 résulte également d'un compromis entre complexité et précision de la surveillance mise en œuvre : en effet, un faible nombre de capteurs fournit un faible nombre de mesures, ce qui se traduit par un gain de temps en maintenance du réseau électrique 2 ; à l'inverse un grand nombre de capteurs fournissant un grand nombre de mesures permet d'améliorer la précision de l'estimation des admittances des éléments critiques.

Dans le mode de réalisation décrit ici, il est choisi d'utiliser autant de capteurs que d'éléments critiques identifiés dans le réseau électrique 2 à l'étape F30. Pour chaque admittance à estimer, le chemin le plus influencé entre la source S et la charge C par les perturbations appliquées à cette admittance est identifié dans le réseau électrique 2. Ce chemin peut comprendre un ou plusieurs éléments du réseau (ex. éléments structurels, segments d'éléments structurels et autres éléments conducteurs de connexion), et est donc représenté dans le graphe par une ou plusieurs branches. Il peut être déterminé au moyen d'un procédé similaire à celui utilisé pour identifier les éléments critiques du réseau électrique 2, c'est-à-dire en tenant compte des sensibilités des tensions aux perturbations appliquées aux admittances des éléments du réseau entre les deux nœuds, ces sensibilités étant évaluées à partir de l'équation (Eq. 5) et des équations reflétant la sensibilité des valeurs propres et des vecteurs propres de la matrice Laplacienne L du graphe.

Dans ce mode de réalisation, la sensibilité est déterminée sur tous les chemins source S - charges C possibles, mais il est également possible, en considérant que certains éléments du réseau électrique 2 peuvent être inaccessibles ou difficilement accessibles, de déterminer les sensibilités des mesures accessibles et de déterminer les meilleures mesures répondant au besoin.

On note que dans l'exemple mentionné ici, on s'attache aux sensibilités des tensions aux extrémités des chemins et des mesures de tensions sont réalisées au moyen des capteurs 4. En variante, il est possible de considérer des mesures de courant de branches ou des mesures de chutes de tension et des mesures de courant de branches.

Les capteurs 4 sont placés aux extrémités de chaque chemin identifié pour chaque élément critique du réseau 2.

On note en outre que pour obtenir des mesures pertinentes pour l'estimation des admittances des éléments critiques, il est préférable de s'assurer que lors de l'excitation du réseau électrique pour réaliser les mesures par les capteurs 4, les éléments critiques du réseau soient traversés par un courant. On choisira donc des points d'injection des courants d'excitation en conséquence. Plusieurs configurations (par exemple un nombre entier K supérieur à 1) peuvent être envisagées à cet effet. Ce choix peut être réalisé dès la conception du réseau électrique 2 et reste figé.

Une fois les capteurs 4 dûment placés dans le réseau électrique, l'estimation paramétrique des admittances des éléments critiques réalisée par le module d'estimation paramétrique 5 est mise en œuvre de la façon suivante, en s'appuyant sur la représentation par le graphe complexe G du réseau électrique 2.

Plus spécifiquement, conformément au modèle numérique MOD utilisé par le module d'estimation paramétrique 5, les potentiels nodaux et les courants nodaux sont liés par le système d'équations (Eq.6) suivant :

$$\begin{cases} M_{inc} * W * M_{inc}{}^{t} * \underline{V} = \underline{I} \\ \underline{dV} = C_{mes} * \underline{V} \end{cases} \qquad (Eq.6)$$

où :

- $M_{inc}$ désigne la matrice d'incidence du graphe complexe G. Cette matrice reflète les interconnexions entre les éléments du réseau électrique 2, autrement dit entre les branches du graphe complexe G représentant ces éléments ;
- $\underline{W}$ est la matrice des poids du graphe G ; il s'agit d'une matrice diagonale dans laquelle chaque élément représente l'admittance d'une branche du réseau. On note que selon les éléments critiques identifiés lors de l'étape F30, tout ou partie des admittances consignées sont à estimer, les autres étant supposées connues ;
- $\underline{V}$ est un vecteur représentant les potentiels nodaux ;
- $\underline{I}$ est un vecteur représentant les courants nodaux injectés pour la mesure ;
- $\underline{dV}$ désigne un vecteur contenant les chutes de tensions mesurées par les capteurs 4 ; et
- $\underline{C}_{mes}$ désigne la matrice dite de combinaison, représentant la matrice d'incidence des mesures ; le nombre de colonnes de cette matrice est égale au nombre de mesures effectuées, tandis que le nombre de lignes est égale à la dimension n du graphe G. La matrice $C_{mes}$ est construite de manière analogue à la matrice d'incidence sauf qu'elle ne décrit plus une branche entre deux nœuds voisins, mais un chemin (qui est la chute de tension mesurée) entre 2 nœuds non voisins.

A titre illustratif, pour mieux comprendre la construction de cette matrice, on considère un exemple basé sur le réseau EX2 illustré à la figure 4A et modélisé par le graphe G(EX2) à la figure 4B (pour un point d'injection du courant d'excitation situé en nœud 11 et une sortie du courant au nœud 15). On suppose qu'on réalise trois mesures de chutes de tension entre les nœuds 6 et 9, entre les nœuds 15 et 24 et entre les nœuds 3 et 9 respectivement. La matrice des combinaisons en résultant est donnée par :

$$
C_{mes} = \begin{pmatrix}
0 & 0 & 0 \\
0 & 0 & 0 \\
0 & 0 & 1 \\
0 & 0 & 0 \\
0 & 0 & 0 \\
1 & 0 & 0 \\
0 & 0 & 0 \\
0 & 0 & 0 \\
-1 & 0 & -1 \\
0 & 0 & 0 \\
0 & 0 & 0 \\
0 & 0 & 0 \\
0 & 0 & 0 \\
0 & 0 & 0 \\
0 & 1 & 0 \\
0 & 0 & 0 \\
0 & 0 & 0 \\
0 & 0 & 0 \\
0 & 0 & 0 \\
0 & 0 & 0 \\
0 & 0 & 0 \\
0 & 0 & 0 \\
0 & 0 & 0 \\
0 & -1 & 0 \\
0 & 0 & 0
\end{pmatrix}
$$

Le système d'équations (Eq.6) peut s'écrire de façon équivalente sous la forme :

$$
\begin{cases}
0 = f(\underline{V},\underline{W},\underline{I}) \\
\underline{dV} = g(\underline{V},\underline{W},\underline{I})
\end{cases}
$$

où f désigne une fonction non linéaire et g désigne une fonction linéaire.

On désigne par K le nombre de jeux de mesures expérimentales réalisés sur le réseau électrique 2 au moyen des capteurs 4 au cours d'une même itération : chaque jeu de mesures correspond par exemple à un point d'injection du courant dans le réseau différent, et comprend les mesures réalisées par les différents capteurs 4 associés à chaque élément critique du réseau.

L'estimation paramétrique réalisée par le module d'estimation 5 consiste alors à estimer les admittances des éléments critiques correspondant le mieux aux K jeux de mesures effectuées.

On désigne dans la suite par $\underline{West}$ l'estimation de la matrice des poids des éléments du réseau 2 : cette matrice comprend les admittances estimées des éléments critiques et les admittances connues des autres éléments du réseau 2. Le module d'estimation paramétrique 5 estime à partir de l'estimation $\underline{West}$ des admittances des éléments du réseau 2 et en utilisant le système d'équations (Eq.6), le vecteur $\underline{dVest}$ des chutes de tension constatées dans le réseau électrique 2 pour chaque jeu de mesures. Ce vecteur vérifie les équations suivantes :

$$\begin{cases} 0 = f(\underline{V_{est}}, \underline{W_{est}}, \underline{I}) \\ \underline{dV} = g(\underline{V_{est}}, \underline{W_{est}}, \underline{I}) \end{cases}$$

Puis il calcule, pour chaque jeu de mesures indexé par k, k=1,...,K, l'erreur d'estimation notée εk entre les chutes de tensions réelles notées $dVreel_k$ mesurées sur le réseau et les chutes de tensions estimées $dVest_k$, soit :

$$\varepsilon_k = dV_{reel_k} - dV_{est_k}(\underline{V_{est}})$$

La valeur optimale de <u>West</u> est alors obtenue par le module d'estimation paramétrique 5 en minimisant l'erreur quadratique entre les chutes de tensions réelles et estimées sur l'ensemble des K jeux de mesures réalisés, soit :

$$\min_{\underline{Y}} \sum_k^K \varepsilon_k^2 = \min_{\underline{Y}} \sum_k^K (dV_{reel_k} - dV_{est_k}(\underline{V_{est}}))^2$$

Le module d'estimation paramétrique 5 considère par ailleurs, pour la minimisation une contrainte physique imposant que les admittances soient positives.

L'estimation paramétrique mise en œuvre par le module d'estimation paramétrique 5 revient à résoudre un problème d'optimisation dont la formulation est explicitée ci-dessous :

$$\min \quad \sum_k^K (dV_{reel_k} - dV_{est_k}(\underline{V_{est}}))^2$$

avec

$$M_{inc} * W_{est} * M_{inc}{}^t * \underline{V_{est}} = \underline{I}$$

$$w_i \geq 0$$

Pour réaliser cette optimisation, le module d'estimation paramétrique 5 peut avoir recours à différentes techniques d'optimisation. Dans le mode de réalisation décrit ici, compte-tenu du nombre de variables à estimer (chutes de tension et admittances des éléments critiques, les autres étant supposées connues), le module d'estimation paramétrique 5 utilise un algorithme des points intérieurs, connu de l'homme du métier et non détaillé ici. Cet algorithme est décrit par exemple dans l'article de Wächter et Biegler intitulé « On the implementation of an interior-point filter line-search algorithm for large-scale nonlinear programming », 2006.

Le module d'estimation paramétrique 5 peut par ailleurs utiliser l'algorithme des points intérieurs en combinaison avec une stratégie permettant d'éviter une convergence de l'algorithme vers des minima locaux. Une telle stratégie peut consister par exemple à appliquer plusieurs fois l'algorithme en modifiant son point de départ (i.e. les valeurs initiale des admittances des branches des contacts critiques).

D'autres algorithmes ayant les mêmes propriétés peuvent être utilisés en variante par le module d'estimation paramétrique 5, comme par exemple l'algorithme de Levenberg-Marquardt.

Dans un autre mode de réalisation de l'invention, le module d'estimation paramétrique 5 estime les admittances des éléments critiques à partir de mesures de chutes de tensions $dV_{reel}$ et à partir de mesures de courant $i_{reel}$. Dans ce cas, le problème d'optimisation à résoudre par le module d'estimation paramétrique 5 s'écrit :

$$\min \quad \sum_k^K (dV_{reel_k} - dV_{est_k}(\underline{V_{est}}))^2 + \sum_j^J (i_{reel_j} - i_{est_j}(\underline{V_{est}}, \underline{Y}))^2$$

avec

$$M_{inc} * W_{est} * M_{inc}{}^{t} * \underline{V}_{est} = \underline{I}$$

$$w_i \geq 0$$

Pour réaliser cette estimation paramétrique, le module d'estimation paramétrique 5 doit non seulement d'estimer les chutes de tension $dV_{est}$ et les poids des branches W mais également les courants nodaux $i_{est}$.

On note que le module d'estimation paramétrique 5 peut mettre en œuvre une technique d'estimation paramétrique itérative (en réitérant les étapes décrites ci-dessus), notamment pour garantir que tous les éléments critiques dont l'admittance doit être estimée sont bien parcourus par un courant lors de la réalisation des mesures, et les admittances estimées sont fiables. Chaque itération peut correspondre à un point d'injection distinct du courant sur le réseau 2 pour réaliser les mesures de sorte à permettre l'estimation de toutes les admittances. Les valeurs d'admittance estimées lors d'une itération sont préférentiellement figées et considérées comme connues à l'itération suivante.

Par ailleurs, il convient de noter que l'estimation paramétrique qui vient d'être décrite peut également être utilisée pour déterminer les admittances des éléments non critiques du réseau 2 lors d'une étape préliminaire. Ces admittances requièrent une unique détermination puisqu'elles sont ensuite considérées comme invariantes au cours du procédé de surveillance. Pour réaliser cette détermination, il suffit de considérer que toutes les admittances de la matrice $L_{est}$ doivent être déterminées (il peut dès lors être nécessaire de considérer un plus grand nombre de capteurs pour réaliser des mesures pertinentes pour l'ensemble des éléments du réseau). Des tests conduits par les inventeurs sur des réseaux simples en utilisant cette méthodologie ont montré que des valeurs très proches des valeurs exactes des admittances peuvent être obtenues aisément.

L'estimation des admittances des éléments critiques du réseau 2 réalisée par le module d'estimation 5 permet alors au module d'évaluation 6 du système de surveillance 1 d'évaluer sur l'ensemble des couples source - charge C considérés, un critère fonctionnel du réseau prédéfini représentatif du fonctionnement du réseau (étape F40). Dans le mode de réalisation décrit ici, le critère fonctionnel évalué est la chute de tension maximale entre chaque charge C et la source S, afin de déterminer si cette chute de tension maximale est conforme à la chute de tension maximale autorisée par la règlementation de 0.5V.

Pour évaluer ce critère fonctionnel, le module d'évaluation 6 définit un modèle estimé du réseau électrique à partir d'une matrice Laplacienne estimée Lest.

Il convient de noter que ce modèle fournit une estimation des paramètres influents du réseau (i.e. des admittances des éléments critiques du réseau) sur les chutes de tensions entre chaque source et chaque charge essentielle mais ne garantit pas les valeurs des admittances des autres éléments du réseau. Un modèle dégradé de la totalité du réseau peut être réalisé en estimant l'ensemble des admittances des éléments du réseau ; une telle estimation requiert toutefois d'installer un grand nombre de capteurs 4 dans le réseau 2 pour disposer des mesures nécessaires à cette estimation. Cette démarche peut être utilisée également pour l'estimation initiale des admittances des éléments du réseau 2 de retour de courant (et plus particulièrement des admittances ou résistances de contact correspondant aux jonctions électromécaniques qui créent des résistances de contact) dès lors que les valeurs de ces admittances ne sont pas connues (les valeurs des admittances des éléments structurels peuvent être obtenues du systémier ou de l'intégrateur aéronautique). La caractérisation initiale des résistances de contact (ou plus généralement des admittances du réseau 2) peut être ainsi mise en œuvre en reprenant les étapes F10, F20, F30 (appliquées à plusieurs reprises) et une étape de validation des admittances estimées en comparant les chutes de tension source-charge estimées via le modèle dérivé des admittances estimées aux chutes de tension source-charge mesurées.

Puis, à partir du courant injecté dans le réseau 2 par chaque charge essentielle C considérée lors du fonctionnement normal de l'avion (ce courant est connu des spécifications de l'intégrateur ou peut être aisément mesuré), le module d'évaluation 6 évalue les chutes de tensions entre la source S et chaque charge C essentielle grâce à l'équation fonctionnelle suivante intégrant les équations circuits :

$$L_{est} * \underline{V} = \underline{I}_{fct}$$

où V désigne dans cette équation fonctionnelle le vecteur des potentiels nodaux en fonctionnement, et $I_{fct}$ le vecteur des courants nodaux injectés par les charges essentielles.

Puisque la matrice Laplacienne $L_{est}$ d'un graphe n'est pas inversible, les potentiels nodaux sont calculés en multipliant le vecteur des courants nodaux par la pseudo-inverse de Moore-Penrose de la matrice Laplacienne $L_{est}$. La chute de tensions entre chaque source et chaque charge essentielle peut alors être obtenue à partir des potentiels nodaux estimés (différence des potentiels entre la source S et chaque charge essentielle C) et est comparée par le module d'évaluation 6 au seuil 0.5V.

Le système de surveillance 1 est alors en mesure, à partir des critères fonctionnels évalués pour chaque couple source charge considéré, de déterminer l'état de fonctionnement du réseau électrique 2 (étape F50).

Si toutes les chutes de tensions constatées entre tous les couples source-charge considérés (c'est-à-dire comprenant les charges « essentielles » au bon fonctionnement de l'avion déterminées à l'étape F10) sont inférieures à 0.5V, alors l'état (de fonctionnement) du réseau électrique 2 de retour de courant est considéré par le module de détermination 7 du système de surveillance 1 comme satisfaisant ou normal.

Sinon, le module de détermination 7 détermine que le réseau électrique 2 est dans un état dégradé ou défaillant et nécessite une maintenance. Les éléments dégradés du réseau peuvent être détectés et localisés aisément au vu des différentes quantités évaluées au cours des étapes F20 à F40 et des éléments critiques identifiés, ce qui permet d'envisager une maintenance, une réparation ou un remplacement de ces éléments et d'anticiper un dysfonctionnement plus important du réseau de retour de courant.

Dans le mode de réalisation décrit ici, le critère fonctionnel évalué pour déterminer l'état du réseau de retour de courant est la chute de tension maximale entre les sources et les charges de l'avion. Toutefois, d'autres critères fonctionnels peuvent être envisagés, en remplacement ou en plus de celui-ci. Par exemple, on peut envisager également comme critère fonctionnel une valeur maximale de variation constatée entre l'admittance estimée pour un élément critique et une valeur nominale de cette admittance (ou de toute autre caractéristique électrique de l'élément), l'état du réseau électrique étant déterminé comme défaillant si pour au moins un élément critique du réseau pour au moins un couple source-charge considéré, cette variation maximale est supérieure à un seuil d'alerte prédéterminé (par exemple 50%). Les valeurs nominales (ou initiales) des admittances peuvent être connues, ou être déterminées via une estimation paramétrique comme décrit à l'étape F40.

L'invention permet ainsi de surveiller aisément l'état de fonctionnement d'un réseau électrique de retour de courant.

Nous allons maintenant décrire brièvement à titre illustratif un exemple d'application de l'invention. On considère ici le réseau de retour de courant modélisé à **la figure 7.** Sur cette figure, le nœud source est représenté par un cercle et les nœuds charges (au nombre de 7) par des carrés. On note que la plupart des nœuds représentés sur la figure 6 qui modélisent un contact entre deux éléments structurels du réseau « cachent » en fait deux nœuds du graphe en raison du contact établi entre les éléments structurels au moyen de jonctions (mais qui n'apparaissent pas en perspective dans le mode de représentation adopté sur cette figure).

Dans cet exemple, on fait l'hypothèse que seules les admittances de contact peuvent être dégradées, les admittances des autres éléments du réseau étant considérées comme fixes et connues. De plus les valeurs initiales des admittances de contact sont supposées connues. Il est par ailleurs fait l'hypothèse que les admittances de contact peuvent diminuer de maximum 70% de leur valeur initiale (autrement dit, les résistances de contacts peuvent varier entre leur valeur initiale et 333 % de cette valeur).

Dans l'exemple envisagé ici, on considère que le graphe modélisant le réseau de retour de courant illustré à la figure 7 comprend 244 nœuds et 284 admittances. Par souci de simplification les nœuds du graphe sont numérotés dans la suite de la description.

Comme indiqué précédemment, on considère 7 charges distinctes situées respectivement aux nœuds 108, 109, 112, 114, 119, 127 et 136, et qui injectent un courant identique de 100 A dans le réseau de retour de courant. La source (de puissance est), quant-à-elle, située au nœud 212. Les chutes de tensions entre la source et les charges en fonctionnement normal (i.e. quand le réseau est dans un état satisfaisant) sont données ci-dessous dans la Table 1). On remarque que le réseau de retour de courant est bien dimensionné car le critère fonctionnel est respecté pour toutes les charges (chutes de tensions entre la source et les charges inférieures à 0,5 V).

Table 1 : Chutes de tensions entre la source et les charges en fonctionnement normal

| | Charge 1 (nœud 108) | Charge 2 (noeud 109) | Charge 3 (noeud 112) | Charge 4 (noeud 114) | Charge 5 (noeud 119) | Charge 6 (noeud 127) | Charge 7 (noeud 136) |
|---|---|---|---|---|---|---|---|
| Chute de tension (V) | 0,4014 | 0,3709 | 0,3657 | 0,2768 | 0,2092 | 0,2415 | 0,3955 |

Dans l'exemple envisagé ici, on suppose qu'un classement préliminaire des charges de sorte à identifier les charges essentielles au bon fonctionnement de l'avion est mis en œuvre (cf. étape F10 précédemment décrite), et que seules les charges situées aux noeuds 112, 127 et 136 sont considérées comme essentielles. Autrement dit, seules les chutes de tensions relatives à ces charges sont surveillées.

En application du procédé de surveillance selon l'invention, les éléments critiques du réseau sont identifiés entre chaque couple source-charge considéré. A cet effet, comme détaillé à l'étape F20, les matrices de sensibilité de chaque chute de tension entre la source et une charge aux variations des admittances sont évaluées grâce à l'étude perturbative du spectre du graphe. Les sensibilités sont calculées uniquement pour les admittances des contacts puisque les admittances des autres branches du réseau sont considérées fixées. Dans cet exemple, le seuil de criticité est fixé à -2 % de modification des chutes de tensions.

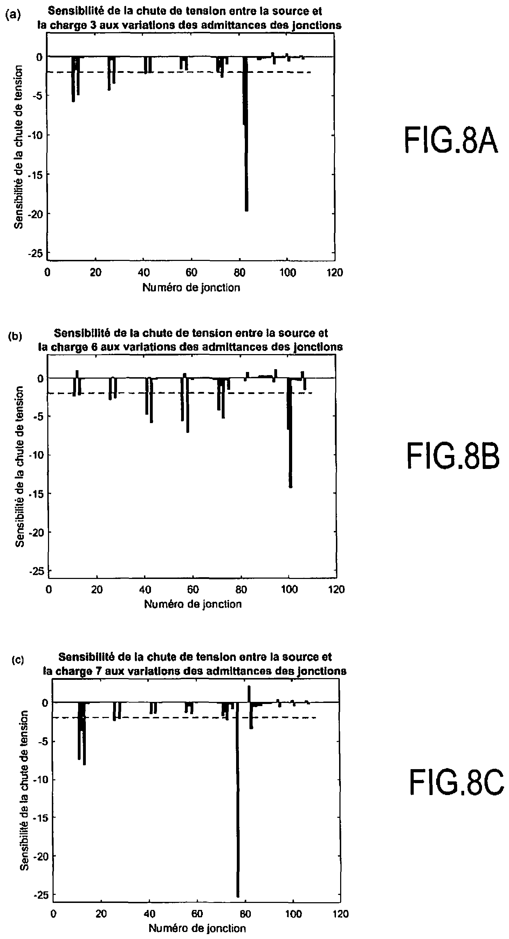

Les sensibilités des chutes de tensions sont calculées et données à la **figure 8,** pour les différentes charges considérées.

On peut remarquer sur cette figure que pour la chute de tension entre la source et la charge 3, il y a 9 branches critiques dont la sensibilité est inférieure à -2 %. Cela signifie que si l'une des admittances de contact correspondant à ces 9 branches critiques diminue de 100 % alors la chute de tension entre la source et la charge augmenterait de plus de 2 %.

Pour la chute de tension entre la source et la charge 6 on trouve 12 branches critiques et pour celle entre la source et la charge 7 il y en a 8.

Cependant, il convient de noter que certaines branches critiques sont communes aux chutes de tensions constatées pour les trois charges. On peut par conséquent limiter à la surveillance à seulement 16 branches critiques pour monitorer les chutes de tensions aux bornes des 3 charges essentielles. Les 16 branches critiques (i.e. éléments critiques du réseau) à surveiller sont les contacts correspondant aux noeuds 11, 12, 13, 26, 28, 41, 43, 56, 58, 71, 73, 77, 82, 83, 100 et 101. Dans la suite, les autres admittances de contact sont considérées comme fixes et égales à leur valeur initiale (même si dans le réseau réel, ces admittances peuvent être amenées à varier).

Les branches correspondant aux éléments critiques à surveiller (désignées dans la suite par « branches critiques ») sont désormais connues et il convient maintenant de déterminer les mesures électriques qui doivent être réalisées dans le réseau pour fournir les bonnes informations à l'estimation paramétrique.

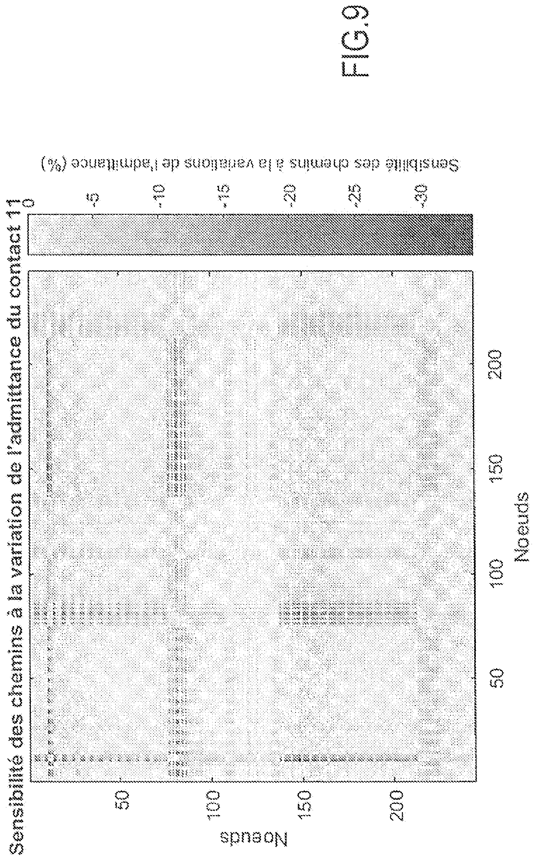

Pour cela les matrices de sensibilités issues de l'étude perturbative du spectre du graphe (étape F20 et E40) sont de nouveau utilisées. On recherche grâce à ces matrices les chemins du réseau les plus influencés par les branches critiques. On suppose ici qu'une mesure de chute de tension est réalisée pour chaque branche critique. La **figure 9** donne une représentation graphique de la matrice de sensibilité des chemins du réseau à la variation de l'admittance de la 1ère branche critique correspondant au noeud 11. On remarque que le chemin entre les noeuds 11 et 148 est le chemin le plus influencé par le contact. On peut noter que ce chemin correspond au chemin entre les bornes du contact 11 car la modification de l'admittance du contact modifie en premier temps la chute de tension de celui-ci. Pour toutes les autres branches critiques les chemins le plus influencés sont aussi les chemins entre les extrémités des branches correspondant aux éléments critiques. Les capteurs sont donc placés aux bornes des contacts critiques afin de réaliser 16 mesures de chutes de tensions. De plus afin de garantir l'excitation des branches critiques, des injections de courant sont réalisées entre leurs bornes.

On note qu'il n'est pas toujours possible d'installer des capteurs aux bornes des contacts puisque la structure de l'avion ne permet pas l'accès à tous les éléments du réseau lors des maintenances. Dans ce cas des contraintes techniques peuvent être rajoutées aux matrices de sensibilité afin de ne prendre en compte que les noeuds accessibles (ceci peut influencer la sélection du chemin le plus influencé par chaque branche critique).

Une fois les capteurs placés, les 16 mesures de tensions sont effectuées. Dans l'exemple envisagé ici, ces mesures sont réalisées à partir d'une simulation numérique dans laquelle les admittances des contacts sont dégradées, leurs admittances ont été choisies aléatoirement entre la moitié de leur valeur initiale et leur valeur initiale.

L'estimation paramétrique décrite à l'étape F30 est ensuite réalisée. Il s'agit de minimiser l'erreur quadratique entre les mesures sur le réseau et les chutes de tensions obtenues par estimation des admittances des branches critiques. Du fait de l'identification des éléments critiques réalisée, les autres admittances de contact sont considérées comme égales à leur valeur initiale dans l'optimisation. Le problème d'optimisation est résolu 15 fois avec différents points initiaux afin d'éviter la convergence vers un minimum local.

L'erreur quadratique obtenue entre les 16 chutes de tensions mesurées sur le réseau réel et celles estimées est de $3,08*10^{-7}$. Cette solution est en moyenne obtenue après 95 itérations en 1 min et 15 secondes. Les estimations des admittances des branches critiques ainsi que les erreurs avec les admittances réelles sont données dans la Table 2 reproduite ci-dessous :

| | Admittance estimée (Ω⁻¹) | Admittance du système réel (Ω⁻¹) | Erreur d'estimation (%) |
|---|---|---|---|
| Contact 11 | 645,2 | 640,9 | 0,66 |
| Contact 12 | 922,6 | 983,7 | -6,21 |
| Contact 13 | 317,2 | 315,7 | 0,46 |
| Contact 26 | 453,4 | 463,3 | -2,15 |
| Contact 28 | 614,9 | 623,3 | -1,34 |
| Contact 41 | 614,2 | 611,7 | 0,41 |
| Contact 43 | 526,2 | 522,9 | 0,64 |
| Contact 56 | 509,0 | 508,2 | 0,16 |
| Contact 58 | 640,3 | 639,5 | 0,13 |
| Contact 71 | 628,1 | 625,2 | 0,47 |
| Contact 73 | 642,9 | 640,6 | 0,36 |
| Contact 77 | 370,2 | 370,2 | 0,00 |
| Contact 82 | 835,1 | 823,3 | 1,44 |
| Contact 13 | 974,3 | 990,0 | -1,58 |
| Contact 100 | 621,6 | 622,1 | -0,09 |
| Contact 101 | 890,8 | 890,2 | 0,07 |

Table 2 : Comparaison entre les admittances estimées et réelles des 16 branches critiques.

Il apparaît dans cette table que l'erreur quadratique est très faible. Les admittances estimées sont pertinentes pour reconstituer les chutes de tensions mesurées sur le système dégradé réel. On remarque en outre que les emplacements des capteurs sont bien définis puisque la minimisation de l'erreur quadratique permet d'obtenir une bonne estimation des admittances du réseau. On note cependant que l'estimation du noeud 12 est légèrement moins bonne avec une erreur de -6,21 %. Ceci peut s'expliquer par l'incertitude existant sur les admittances des éléments (et plus particulièrement des contacts) non critiques du réseau. Pour améliorer cette estimation, un autre seuil de criticité peut être considéré afin de prendre en compte un nombre d'éléments critiques plus importants.

L'estimation paramétrique a donc permis d'estimer correctement les admittances des éléments critiques du réseau.

Afin de vérifier le critère fonctionnel de chute de tensions entre la source et les charges essentielles, le modèle estimé du réseau dégradé est construit à partir des admittances de contact critiques estimées lors de l'estimation paramétriques. Les admittances des contacts non critiques et des autres éléments sont égales à leur valeur initiale.

Les potentiels de l'ensemble des nœuds du réseau de retour de courant lors de son fonctionnement normal sont estimés au moyen du modèle fonctionnel :

$$V_{est} = L_{est}^{*} * I_{fct}$$

La Table 3 reproduite ci-dessous reporte les chutes de tensions estimées entre la source et les 3 charges essentielles :

| | Chute de tension estimée (V) | Chute de tension du système réel (V) | Erreur d'estimation (%) |
|---|---|---|---|
| Charge 3 | 0,3957 | 0,4001 | -1,1 |
| Charge 6 | 0,2684 | 0,2704 | -0,7 |
| Charge 7 | 0,5931 | 0,5969 | -0,6 |

Table 3 : Comparaison entre chutes de tensions estimées et réelles du réseau dégradé

D'après les estimations des admittances des branches critiques, le réseau de retour de courant est fonctionne! pour les 3 charges essentielles. Cependant les chutes de tensions des charges 3 et 7 sont proches de la limite de 0,5 V. Les chutes de tensions réelles permettent la même conclusion. Pour les charges essentielles, l'erreur d'estimation maximale enregistrée est de 1,1%, ce qui demeure extrêmement précis.

Cet exemple montre bien que la surveillance proposée par l'invention permet d'obtenir une bonne approximation de l'évolution des chutes de tensions entre la source et les charges essentielles lors de la dégradation du réseau de retour de courant. La précision de l'estimation peut être améliorée en diminuant le seuil de criticité et donc en estimant davantage de branches critiques.

## Revendications

**1.** Procédé d'identification d'éléments critiques d'un réseau électrique (2) maillé de retour de courant d'un aéronef, ledit aéronef comprenant au moins une structure en matériau composite, ledit réseau électrique comprenant une pluralité d'éléments conducteurs, ledit procédé d'identification étant **caractérisé en ce qu'**il comprend :

- une étape de modélisation (E10) du réseau électrique au moyen d'un graphe comprenant une pluralité de nœuds et une pluralité de branches reliant ces nœuds, chaque nœud du graphe correspondant à un point de connexion entre deux éléments du réseau, chaque branche entre deux nœuds représentant un élément du réseau, ledit graphe étant représenté par une matrice reflétant la topologie du réseau et comprenant des valeurs d'une caractéristique électrique des éléments du réseau représentés par les branches du graphe ;
- une étape de détermination (E20) des valeurs propres et des vecteurs propres de la matrice représentant le graphe ;
- une étape d'estimation (E30), à partir des vecteurs propres et des valeurs propres de la matrice, et pour chaque élément d'une pluralité d'éléments du réseau représenté par une branche du graphe, d'une sensibilité d'une propriété électrique déterminée entre une source et une charge connectées au réseau électrique à une perturbation de la valeur de la caractéristique électrique de cet élément ; et
- une étape de détermination (E40), parmi les éléments du réseau, d'éléments critiques au regard d'un état de fonctionnement du réseau, un élément du réseau étant déterminé comme critique lorsque la sensibilité de la propriété électrique estimée pour cet élément dépasse un seuil de criticité prédéterminé.

**2.** Procédé d'identification selon la revendication 1 dans lequel :

- la caractéristique électrique est une admittance de l'élément du réseau ;
- la matrice du graphe est une matrice Laplacienne ; et
- la propriété électrique est une tension électrique entre la source et la charge.

**3.** Procédé de surveillance d'un réseau électrique maillé de retour de courant d'un aéronef, ledit aéronef comprenant au moins une structure en matériau composite, ledit réseau électrique comprenant une pluralité d'éléments conducteurs, ledit procédé de surveillance comprenant :

- une étape d'identification (F20) d'au moins un élément critique du réseau, pour au moins un couple source-charge comprenant une source et une charge de l'aéronef connectées au réseau, en utilisant un procédé d'identification selon la revendication 1 ou 2 ;
- une étape d'estimation (F30) paramétrique d'une valeur de la caractéristique électrique de chaque élément critique, cette étape utilisant un modèle numérique modélisant un comportement électrique du réseau en fonction de ladite caractéristique électrique et des mesures électriques réalisées au moyen de capteurs positionnés dans le réseau et permettant d'évaluer ledit comportement électrique, un capteur étant positionné dans le réseau pour chaque élément critique sur au moins un élément du réseau ou sur au moins un chemin du réseau formé d'une pluralité d'éléments du réseau influencé par une perturbation de la caractéristique électrique de cet élément critique ;
- une étape d'évaluation (F40), pour ledit au moins un couple source-charge, d'un critère fonctionnel du réseau prédéfini, cette étape d'évaluation utilisant la valeur de la caractéristique électrique estimée pour chaque élément critique ; et
- une étape de détermination (F50) d'un état du réseau électrique en tenant compte du critère fonctionnel évalué pour ledit au moins un couple source-charge.

**4.** Procédé de surveillance selon la revendication 3 dans lequel le critère fonctionnel évalué est une valeur maximale d'une chute de tension constatée entre chaque source et chaque charge, l'état du réseau électrique étant déterminé comme satisfaisant si cette chute de tension est, pour chaque couple source-charge, inférieure à ladite valeur maximale.

5. Procédé de surveillance selon la revendication 3 dans lequel le critère fonctionnel évalué est une variation constatée entre la caractéristique électrique estimée pour un élément critique et une valeur nominale de cette caractéristique électrique, l'état du réseau électrique étant déterminé comme défaillant si pour au moins un élément critique du réseau pour au moins un couple source-charge, cette variation est supérieure à un seuil d'alerte prédéterminé.

6. Procédé de surveillance selon l'une quelconque des revendications 3 à 5 comprenant en outre une étape préliminaire (F10) de sélection, parmi une pluralité de charges de l'aéronef connectées au réseau électrique, d'au moins une charge considérée comme essentielle au regard du fonctionnement de l'aéronef, les étapes d'identification, d'estimation paramétrique, et d'évaluation étant appliquées uniquement aux couples source-charge comprenant ladite au moins une charge essentielle sélectionnée.

7. Procédé de surveillance selon l'une quelconque des revendications 3 à 6 dans lequel lors de l'étape d'estimation paramétrique, on utilise autant de capteurs que d'éléments critiques identifiés, chaque capteur étant associé à un élément critique et placé sur l'élément ou sur le chemin du réseau le plus influencé par une perturbation de la valeur de caractéristique électrique de cet élément critique.

8. Procédé de surveillance selon l'une quelconque des revendications 3 à 7 dans lequel l'étape d'estimation paramétrique met en œuvre une technique d'optimisation dite des points intérieurs sur une pluralité d'itérations.

9. Procédé de surveillance selon l'une quelconque des revendications 3 à 8 comprenant une étape préalable de caractérisation initiale des caractéristiques électriques à partir du graphe modélisant le réseau, de la matrice représentant le graphe et de mesures électriques réalisées dans le réseau.

10. Dispositif (3) d'identification de points de connexion critiques dans un réseau électrique maillé de retour de courant d'un aéronef, ledit aéronef comprenant au moins une structure en matériau composite, ledit réseau électrique comprenant une pluralité d'éléments conducteurs, ledit dispositif d'identification étant **caractérisé en ce qu'**il comprend :

- un module de modélisation (3A), configuré pour modéliser le réseau électrique au moyen d'un graphe comprenant une pluralité de noeuds et une pluralité de branches reliant ces nœuds, chaque nœud du graphe correspondant à un point de connexion entre deux éléments du réseau, chaque branche entre deux nœuds représentant un élément du réseau, ledit graphe étant représenté par une matrice reflétant la topologie du réseau et comprenant des valeurs d'une caractéristique électrique des éléments du réseau représentés par les branches du graphe ;
- un module de détermination (3B), configuré pour déterminer des valeurs propres et des vecteurs propres de la matrice représentant le graphe ;
- un module d'estimation (3C), configuré pour estimer à partir des vecteurs propres et des valeurs propres de la matrice, et pour chaque élément du réseau représenté par une branche du graphe, d'une sensibilité d'une propriété électrique déterminée entre une source et une charge connectées au réseau électrique à une perturbation de la valeur de la caractéristique électrique de cet élément ; et
- un module de détermination (3D), configuré pour déterminer parmi les éléments du réseau, des éléments critiques au regard d'un état de fonctionnement du réseau, un élément étant déterminé comme critique lorsque la sensibilité de la propriété électrique estimée pour cet élément dépasse un seuil de criticité prédéterminé.

11. Système de surveillance (1) d'un réseau électrique maillé de retour de courant d'un aéronef, ledit aéronef comprenant au moins une structure en matériau composite, ledit réseau électrique comprenant une pluralité d'éléments conducteurs, ledit système de surveillance comprenant :

- un dispositif d'identification (3) selon la revendication 10, apte à identifier pour au moins un couple source-charge comprenant une source et une charge de l'aéronef connectées au réseau, au moins un élément critique au regard du fonctionnement du réseau parmi les éléments du réseau ;
- une pluralité de capteurs (4) positionnés dans le réseau et aptes à réaliser des mesures électriques ;
- un module d'estimation paramétrique (5), configuré pour estimer une valeur de la caractéristique électrique de chaque élément critique, ce module utilisant un modèle numérique modélisant un comportement électrique du réseau en fonction de ladite caractéristique électrique et des mesures électriques réalisées au moyen desdits capteurs et permettant d'évaluer le comportement électrique, un capteur étant positionné dans le réseau pour chaque élément critique sur au moins un élément du réseau ou sur au moins un chemin du réseau formé d'une pluralité d'éléments du réseau influencé par une perturbation de la caractéristique électrique de cet élément critique ;

- un module d'évaluation (6), configuré pour évaluer pour ledit au moins un couple source-charge, un critère fonctionnel du réseau prédéfini, ce module utilisant la valeur de la caractéristique électrique estimée pour chaque élément critique ; et

- un module de détermination (7), configuré pour déterminer un état de fonctionnement du réseau électrique en tenant compte du critère fonctionnel évalué pour ledit au moins un couple source-charge considéré.

**Patentansprüche**

1. Verfahren zur Identifizierung kritischer Elemente eines vermaschten elektrischen Stromrückführungsnetzes (2) eines Flugzeugs, wobei das Flugzeug mindestens eine Struktur aus Verbundmaterial umfasst, wobei das elektrische Netz eine Vielzahl leitender Elemente umfasst, wobei das Identifizierungsverfahren **dadurch gekennzeichnet ist, dass** es umfasst:

   - einen Modellierungsschritt (E10) des elektrischen Netzes mittels eines Graphen, der eine Vielzahl von Knoten und eine Vielzahl von Abzweigungen umfasst, die diese Knoten verbinden, wobei jeder Knoten des Graphen einem Verbindungspunkt zwischen zwei Elementen des Netzes entspricht, wobei jede Abzweigung zwischen zwei Knoten ein Element des Netzes darstellt, wobei der Graph durch eine Matrix dargestellt ist, die die Topologie des Netzes widerspiegelt und Werte eines elektrischen Merkmals der Elemente des Netzes umfasst, die durch die Abzweigungen des Graphen dargestellt sind;
   - einen Bestimmungsschritt (E20) der eigenen Werte und der eigenen Vektoren der Matrix, die den Graphen darstellt;
   - einen Schätzschritt (E30), ausgehend von den eigenen Vektoren und den eigenen Werten der Matrix und für jedes Element einer Vielzahl von Elementen des Netzes, das durch eine Abzweigung des Graphen dargestellt ist, einer Sensibilität einer bestimmten elektrischen Eigenschaft zwischen einer Quelle und einer Last, die an das elektrische Netz angeschlossen sind, für eine Störung des Wertes des elektrischen Merkmals dieses Elements; und
   - einen Bestimmungsschritt (E40), von den Elementen des Netzes, kritischer Elemente im Hinblick auf einen Betriebszustand des Netzes, wobei ein Element des Netzes als kritisch bestimmt wird, wenn die Sensibilität der für dieses Element geschätzten elektrischen Eigenschaft einen vorher festgelegten Kritizitätsgrenzwert überschreitet.

2. Identifizierungsverfahren nach Anspruch 1, wobei:

   - das elektrische Merkmal eine Admittanz des Elements des Netzes ist;
   - die Matrix des Graphen eine Laplace-Matrix ist; und
   - die elektrische Eigenschaft eine elektrische Spannung zwischen der Quelle und der Last ist.

3. Verfahren zur Überwachung eines vermaschten elektrischen Stromrückführungsnetzes eines Flugzeugs, wobei das Flugzeug mindestens eine Struktur aus Verbundmaterial umfasst, wobei das elektrische Netz eine Vielzahl leitender Elemente umfasst, wobei das Überwachungsverfahren umfasst:

   - einen Identifizierungsschritt (F20) mindestens eines kritischen Elements des Netzes für mindestens ein Quelle-Last-Paar, das eine Quelle und eine Last des Flugzeugs umfasst, die an das Netz angeschlossen sind, durch Verwenden eines Identifizierungsverfahrens nach Anspruch 1 oder 2;
   - einen parametrischen Schätzschritt (F30) eines Wertes des elektrischen Merkmals jedes kritischen Elements, wobei dieser Schritt ein numerisches Modell verwendet, das ein elektrisches Verhalten des Netzes in Abhängigkeit von dem elektrischen Merkmal und der elektrischen Messungen modelliert, die mit Hilfe von Sensoren durchgeführt werden, die im Netz positioniert sind, und gestattet, das elektrische Verhalten zu beurteilen, wobei ein Sensor im Netz für jedes kritische Element auf mindestens einem Element des Netzes oder auf mindestens einem Pfad des Netzes positioniert ist, der von einer Vielzahl von Elementen des Netzes gebildet ist, das von einer Störung des elektrischen Merkmals dieses kritischen Elements beeinflusst wird;
   - einen Beurteilungsschritt (F40), für das mindestens eine Quelle-Last-Paar, eines vorher festgelegen Betriebskriteriums des Netzes, wobei dieser Beurteilungsschritt den Wert des für jedes kritische Element geschätzten elektrischen Merkmals verwendet; und
- einen Bestimmungsschritt (F50) eines Zustands des elektrischen Netzes unter Berücksichtigung des für das mindestens eine Quelle-Last-Paar beurteilten Betriebskriteriums.

4. Überwachungsverfahren nach Anspruch 3, wobei das beurteilte Betriebskriterium ein maximaler Wert eines Spannungsabfalls ist, der zwischen jeder Quelle und jeder Last festgestellt wird, wobei der Zustand des elektrischen Netzes als zufriedenstellend bestimmt wird, wenn dieser Spannungsabfall für jedes Quelle-Last-Paar unter dem maximalen Wert liegt.

5. Überwachungsverfahren nach Anspruch 3, wobei das beurteilte Betriebskriterium eine Schwankung ist, die zwischen dem für ein kritisches Element geschätzten elektrischen Merkmal und einem nominalen Wert dieses elektrischen Merkmals festgestellt wird, wobei der Zustand des elektrischen Netzes als fehlerhaft bestimmt wird, wenn diese Schwankung für mindestens ein kritisches Element des Netzes für mindestens ein Quelle-Last-Paar größer als ein vorher festgelegter Warngrenzwert ist.

6. Überwachungsverfahren nach einem der Ansprüche 3 bis 5, umfassend ferner einen vorherigen Auswahlschritt (F10) aus einer Vielzahl von Lasten des Flugzeugs, die an das elektrische Netz angeschlossen sind, mindestens einer Last, die im Hinblick auf den Betrieb des Flugzeugs als wesentlich betrachtet wird, wobei die Schritte der Identifizierung, parametrischen Schätzung und Beurteilung nur auf die Quelle-Last-Paare angewendet werden, die die mindestens eine ausgewählte wesentliche Last umfassen.

7. Überwachungsverfahren nach einem der Ansprüche 3 bis 6, wobei beim parametrischen Schätzschritt ebenso viele Sensoren wie identifizierte kritische Elemente verwendet werden, wobei jeder Sensor einem kritischen Element zugeordnet ist und auf dem Element oder auf dem Pfad des Netzes platziert ist, das von einer Störung des Wertes des elektrischen Merkmals dieses kritischen Elements am meisten beeinflusst wird.

8. Überwachungsverfahren nach einem der Ansprüche 3 bis 7, wobei der parametrische Schätzschritt eine Optimierungstechnik der inneren Punkte über eine Vielzahl von Iterationen durchführt.

9. Überwachungsverfahren nach einem der Ansprüche 3 bis 8, umfassend, ausgehend von dem Graphen, der das Netz modelliert, der Matrix, die den Graphen darstellt, und der im Netz durchgeführten elektrischen Messungen, einen vorherigen Erstcharakterisierungsschritt der elektrischen Merkmale.

10. Vorrichtung (3) zur Identifizierung von kritischen Anschlusspunkten in einem vermaschten elektrischen Stromrückführungsnetz eines Flugzeugs, wobei das Flugzeug mindestens eine Struktur aus Verbundmaterial umfasst, wobei das elektrische Netz eine Vielzahl leitender Elemente umfasst, wobei die Identifizierungsvorrichtung **dadurch gekennzeichnet ist, dass** sie umfasst:

    - ein Modellierungsmodul (3A), das ausgelegt ist, um das elektrische Netz mittels eines Graphen zu modellieren, der eine Vielzahl von Knoten und eine Vielzahl von Abzweigungen umfasst, die diese Knoten verbinden, wobei jeder Knoten des Graphen einem Verbindungspunkt zwischen zwei Elementen des Netzes entspricht, wobei jede Abzweigung zwischen zwei Knoten ein Element des Netzes darstellt, wobei der Graph durch eine Matrix dargestellt ist, die die Topologie des Netzes widerspiegelt und Werte eines elektrischen Merkmals der Elemente des Netzes umfasst, die durch die Abzweigungen des Graphen dargestellt sind;
    - ein Bestimmungsmodul (3B), das ausgelegt ist, um eigene Werte und eigene Vektoren der Matrix, die den Graphen darstellt, zu bestimmen;
    - ein Schätzmodul (3C), das ausgelegt ist, um ausgehend von den eigenen Vektoren und den eigenen Werten der Matrix und für jedes Element des Netzes, das durch eine Abzweigung des Graphen dargestellt ist, eine Sensibilität einer bestimmten elektrischen Eigenschaft zwischen einer Quelle und einer Last, die an das elektrische Netz angeschlossen sind, für eine Störung des Wertes des elektrischen Merkmals dieses Elements zu schätzen; und
    - ein Bestimmungsmodul (3D), das ausgelegt ist, um von den Elementen des Netzes kritische Elemente im Hinblick auf einen Betriebszustand des Netzes zu bestimmen, wobei ein Element als kritisch bestimmt wird, wenn die Sensibilität der für dieses Element geschätzten elektrischen Eigenschaft einen vorher festgelegten Kritizitätsgrenzwert überschreitet.

11. System zur Überwachung (1) eines vermaschten elektrischen Stromrückführungsnetzes eines Flugzeugs, wobei das Flugzeug mindestens eine Struktur aus Verbundmaterial umfasst, wobei das elektrische Netz eine Vielzahl leitender Elemente umfasst, wobei das Überwachungssystem umfasst:

- eine Identifizierungsvorrichtung (3) nach Anspruch 10, die imstande ist, für mindestens ein Quelle-Last-Paar, das eine Quelle und eine Last des Flugzeugs umfasst, die an das Netz angeschlossen sind, von den Elementen des Netzes mindestens ein im Hinblick auf den Betrieb des Netzes kritisches Element zu identifizieren;
- eine Vielzahl von Sensoren (4), die im Netz positioniert sind und imstande, elektrische Messungen durchzuführen;
- ein parametrisches Schätzmodul (5), das ausgelegt ist, um einen Wert des elektrischen Merkmals jedes kritischen Elements zu schätzen, wobei dieses Modul ein numerisches Modell verwendet, das ein elektrisches Verhalten des Netzes in Abhängigkeit von dem elektrischen Merkmal und elektrischen Messungen modelliert, die mit Hilfe der Sensoren durchgeführt werden, und gestattet, das elektrische Verhalten zu beurteilen, wobei ein Sensor im Netz für jedes kritische Element auf mindestens einem Element des Netzes oder auf mindestens einem Pfad des Netzes positioniert ist, der von einer Vielzahl von Elementen des Netzes gebildet ist, das von einer Störung des elektrischen Merkmals dieses kritischen Elements beeinflusst wird;
- ein Beurteilungsmodul (6), das ausgelegt ist, um für das mindestens eine Quelle-Last-Paar ein vorher festgelegtes Betriebskriteriums des Netzes zu beurteilen, wobei dieses Modul den Wert des für jedes kritische Element geschätzten elektrischen Merkmals verwendet; und
- ein Bestimmungsmodul (7), das ausgelegt ist, um einen Betriebszustand des elektrischen Netzes unter Berücksichtigung des für das mindestens eine Quelle-Last-Paar beurteilten Betriebskriteriums zu bestimmen.

**Claims**

1. A method for identifying critical elements of a meshed current return electrical network (2) of an aircraft, said aircraft comprising at least one structure made of composite material, said electrical network comprising a plurality of conductive elements, said identification method being **characterized in that** it comprises:

- a step of modelling (E10) the electrical network by means of a graph comprising a plurality of nodes and a plurality of branches connecting these nodes, each node of the graph corresponding to a connection point between two elements of the network, each branch between two nodes representing an element of the network, said graph being represented by a matrix reflecting the topology of the network and comprising values of an electrical characteristic of the elements of the network represented by the branches of the graph;
- a step of determining (E20) the eigenvalues and eigenvectors of the matrix representing the graph;
- an step of estimating (E30), from the eigenvectors and eigenvalues of the matrix, and for each element of a plurality of elements of the network represented by a branch of the graph, a sensitivity of a determined electrical property between a source and a load that are connected to the electrical network at a disturbance in the value of the electrical characteristic of this element; and
- a step of determining (E40), among the elements of the network, critical elements with regard to a state of operation of the network, an element of the network being determined as critical when the sensitivity of the electrical property estimated for this element exceeds a predetermined criticality threshold.

2. The identification method according to claim 1 wherein:

- the electrical characteristic is an admittance of the element of the network;
- the matrix of the graph is a Laplacian matrix; and
- the electrical property is an electrical voltage between the source and the load.

3. A method for monitoring a meshed current return electrical network of an aircraft, said aircraft comprising at least one structure made of composite material, said electrical network comprising a plurality of conductive elements, said monitoring method comprising:

- a step of identifying (F20) at least one critical element of the network, for at least one source-load pair comprising a source and a load of the aircraft that are connected to the network, by using an identification method according to the claim 1 or 2;
- a step of parametrically estimating (F30) a value of the electrical characteristic of each critical element, this step using a numerical model modelling an electrical behavior of the network as a function of said electrical characteristic and of the electrical measurements performed by means of sensors positioned in the network and making it possible to evaluate said electrical behavior, a sensor being positioned in the network for each critical element on at least one element of the network or on at least one path of the network formed by a plurality of elements of the network affected by a disturbance in the electrical characteristic of this critical element;
- a step of evaluating (F40), for said at least one source-load pair, an operational criterion of the predefined network, this evaluation step using the value of the electrical characteristic estimated for each critical element; and
- a step of determining (F50) a state of the electrical network by taking into account the operational criterion evaluated for said at least one source-load pair.

4. The monitoring method according to claim 3 wherein the operational criterion evaluated is a maximum value of a voltage drop observed between each source and each load, the state of the electrical network being determined as satisfactory if this voltage drop is, for each source-load pair, less than said maximum value.

5. The monitoring method according to claim 3 wherein the operational criterion evaluated is a variation observed between the electrical characteristic estimated for a critical element and a nominal value of this electrical characteristic, the state of the electrical network being determined as faulty if for at least one critical element of the network for at least one source-load pair, this variation is greater than a predetermined alert threshold.

6. The monitoring method according to any one of claims 3 to 5 further comprising a preliminary step (F10) of selecting, among a plurality of loads of the aircraft that are connected to the electrical network, at least one load considered to be essential with regard to the operation of the aircraft, the identification, parametric estimation and evaluation steps being applied only to the source-load pairs comprising said at least one selected essential load.

7. The monitoring method according to any one of claims 3 to 6 wherein during the parametric estimation step, there are as many sensors used as identified critical elements, each sensor being associated with a critical element and placed on the network element or on the network path most affected by a disturbance in the value of the electrical characteristic of this critical element.

8. The monitoring method according to any one of claims 3 to 7 wherein the parametric estimation step implements a technique of optimization known as technique of optimization of the interior points on a plurality of iterations.

9. The monitoring method according to any one of claims 3 to 8 comprising a prior step of initially characterizing the electrical characteristics from the graph modelling the network, from the matrix representing the graph and from electrical measurements performed in the network.

10. A device (3) for identifying critical connection points in a meshed current return electrical network of an aircraft, said aircraft comprising at least one structure made of composite material, said electrical network comprising a plurality of conductive elements, said identification device being **characterized in that** it comprises:

    - a modelling module (3A) configured to model the electrical network by means of a graph comprising a plurality of nodes and a plurality of branches connecting these nodes, each node of the graph corresponding to a connection point between two elements of the network, each branch between two nodes representing an element of the network, said graph being represented by a matrix reflecting the topology of the network and comprising values of an electrical characteristic of the elements of the network represented by the branches of the graph;
    - a determination module (3B) configured to determine the eigenvalues and eigenvectors of the matrix representing the graph;
    - an estimation module (3C) configured to estimate, from the eigenvectors and eigenvalues of the matrix, and for each element of the network represented by a branch of the graph, a sensitivity of an electrical property determined between a source and a load that are connected to the electrical network at a disturbance in the value of the electrical characteristic of this element; and
    - a determination module (3D) configured to determine, among the elements of the network, critical elements with regard to an operating state of the network, an element being determined as critical when the sensitivity of the electrical property estimated for this element exceeds a predetermined criticality threshold.

11. A system for monitoring (1) a meshed current return electrical network of an aircraft, said aircraft comprising at least one structure made of composite material, said electrical network comprising a plurality of conductive elements, said monitoring system comprising:

    - an identification device (3) according to claim 10 able to identify, for at least one source-load pair comprising a source and a load of the aircraft connected to the network, at least one critical element with regard to the operation of the network among the elements of the network;

- a plurality of sensors (4) positioned in the network and able to perform electrical measurements;

- a parametric estimation module (5) configured to estimate a value of the electrical characteristic of each critical element, this module using a numerical model modelling an electrical behavior of the network as a function of said electrical characteristic and of the electrical measurements performed by means said sensors and making it possible to evaluate the electrical behavior, a sensor being positioned in the network for each critical element on at least one element of the network or on at least one path of the network formed by a plurality of elements of the network affected by a disturbance in the electrical characteristic of this critical element;

- an evaluation module (6) configured to evaluate, for said at least one source-load pair, an operational criterion of the predefined network, this module using the value of the electrical characteristic estimated for each critical element; and

- a determination module (7) configured to determine an operating state of the electrical network by taking into account the operational criterion evaluated for said at least one source-load pair considered.

# FIG.1

2

1

8

| 3A | 3B |
| 3C | 3D |

3

5

6

7

4

---

| Modélisation du réseau électrique au moyen d'un graphe G représenté par sa matrice Laplacienne L | E10 |

| Analyse spectrale du graphe G et extraction des vecteurs propres et des valeurs propres de la matrice L | E20 |

# FIG.2

| Estimation de la sensibilité de la chute de tension Vsc entre une source S et une charge C à une variation de l'admittance des éléments du réseau | E30 |

| Identification des éléments critiques pour la source S et la charge C | E40 |

FIG.3A

FIG.3B

FIG.4A

FIG.4B

| Classement des charges et sélection des charges essentielles au bon fonctionnement de l'aéronef | ⌐ F10 |

| Identification des éléments critiques pour les charges essentielles sélectionnées | ⌐ F20 |

| Estimation paramétrique des admittances des éléments critiques identifiés | ⌐ F30 |

| Evaluation du critère fonctionnel sur l'ensemble des charges essentielles | ⌐ F40 |

| Détermination de l'état du réseau de retour de courant | ⌐ F50 |

FIG.5

FIG.6

FIG.7

(a) Sensibilité de la chute de tension entre la source et
la charge 3 aux variations des admittances des jonctions

FIG.8A

(b) Sensibilité de la chute de tension entre la source et
la charge 6 aux variations des admittances des jonctions

FIG.8B

(c) Sensibilité de la chute de tension entre la source et
la charge 7 aux variations des admittances des jonctions

FIG.8C

Sensibilité des chemins à la variation de l'admittance du contact 11

FIG.9

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 2653859 A

- FR 2997507 A1

**Littérature non-brevet citée dans la description**

- **WÄCHTER ; BIEGLER.** *On the implementation of an interior-point filter line-search algorithm for large-scale nonlinear programming,* 2006